# EUROPEAN PATENT APPLICATION

(11) **EP 4 719 035 A2**
(43) Date of publication of application: **01.04.2026**
(21) Application number: 25199802.7
(22) Date of filing: 03.09.2025
(51) Int. Cl.: H10W 44/20, H10W 20/41, H10W 20/40, H10W 42/20, H10W 70/09, H10W 70/60, H10W 90/20

(54) **SEMICONDUCTOR PACKAGE AND SEMICONDUCTOR PACKAGE ASSEMBLY**

(30) Priority: 06.09.2024 US 202463691412 P; 23.07.2025 US 202519277737
(71) Applicant: MEDIATEK INC., Hsinchu City 30078 (TW)
(72) Inventor: YANG, Yu-Tao, San Jose, California (US); HUNG, Chih-Ming, San Jose, California (US)
(74) Representative: Haseltine Lake Kempner LLP

(57) **Abstract**

A semiconductor package and a semiconductor package assembly are provided. The semiconductor package includes an interconnect structure, a chip, a redistribution layer (RDL), a molding compound, and through mold vias (TMVs). The chip is arranged on and coupled to the interconnect structure. The RDL is arranged on and coupled to the chip. The molding compound is arranged on the interconnect structure and encapsulates the chip and the RDL. The TMVs pass through the molding compound and are connected between the RDL and the interconnect structure. The chip includes a back-side connect structure, a transistor layer, a front-side connect structure and a carrier. The back-side connect structure is connected to the interconnect structure. The transistor layer is located on the back-side connect structure. The front-side connect structure is located on the transistor layer. The first carrier is located on and coupled to the interconnect structure.

## Description

### CROSS REFERENCE TO RELATED APPLICATIONS

This application claims the benefit of U.S. Provisional Application No. 63/691,412, filed on September 6, 2024, the entirety of which is incorporated by reference herein.

### BACKGROUND OF THE DISCLOSURE

### Field of the Disclosure

The present disclosure relates to a semiconductor package and a semiconductor package assembly, in particular, it relates to a semiconductor package and a semiconductor package assembly including a chip having back-side power delivery network.

### Description of the Related Art

In order to ensure the continued miniaturization and multi-functionality of electronic products and communication devices, it is desired that semiconductor packages be small in size, support multi-pin connection, operate at high speeds, and have high functionality. This will put pressure on semiconductor package fabricators to develop high density interconnects for signal routing and power delivery.

Although existing semiconductor packages have generally been adequate for their intended purposes, they have not been satisfactory in all respects. Thus, a novel semiconductor packages is desirable to improve the signal integrity (SI), power integrity (PI) , thermal conduction and voltage (IR) drop issues in high density interconnects.

### BRIEF SUMMARY OF THE DISCLOSURE

An embodiment of the present disclosure provides a semiconductor package. The semiconductor package includes a first interconnect structure, a first chip, a first redistribution layer (RDL), a molding compound, and through mold vias (TMVs). The first chip is arranged on and coupled to the first interconnect structure. The first redistribution layer (RDL) is arranged on and coupled to the first chip. The molding compound is arranged on the first interconnect structure and encapsulates the first chip and the first RDL. The through mold vias (TMVs) pass through the molding compound and are connected between the first RDL and the first interconnect structure. The first chip includes a first back-side connect structure, a first transistor layer, a first front-side connect structure and a first carrier. The first back-side connect structure is connected to the first interconnect structure. The first transistor layer is located on the first back-side connect structure. The first front-side connect structure is located on the first transistor layer. The first carrier is located on and coupled to the first interconnect structure.

An embodiment of the present disclosure provides a semiconductor package assembly. The semiconductor package assembly includes a base and a semiconductor package mounted on the base. The semiconductor package includes a first interconnect structure, a first chip, a first redistribution layer (RDL), a molding compound and through mold vias (TMVs). The first chip is arranged on and coupled to the first interconnect structure. The first redistribution layer (RDL) is arranged on and coupled to the first chip. The molding compound is arranged on the first interconnect structure and encapsulates the first chip and the first RDL. The through mold vias (TMVs) passes through the molding compound and are connected between the first RDL and the first interconnect structure. The first chip includes a first back-side connect structure, a first transistor layer, a first front-side connect structure, and a first carrier. The first back-side connect structure is connected to the first interconnect structure. The first transistor layer is located on the first back-side connect structure. The first front-side connect structure is located on the first transistor layer. The first carrier is located on the first front-side connect structure and coupled to the first interconnect structure. The first back-side connect structure is located close to the first interconnect structure and the first carrier is located close to and coupled to the first RDL. Alternatively, the first carrier is located close to the first interconnect structure and the first back-side connect structure is located close to and coupled to the first RDL.

### BRIEF DESCRIPTION OF THE DRAWINGS

The present disclosure can be more fully understood by reading the subsequent detailed description and examples with references made to the accompanying drawings, wherein:
FIG. 1 is a schematic cross-sectional view of a semiconductor package in accordance with some embodiments of the disclosure;
FIG. 2 is a schematic cross-sectional view of a semiconductor package in accordance with some embodiments of the disclosure;
FIG. 3 is a schematic cross-sectional view of a semiconductor package in accordance with some embodiments of the disclosure;
FIG. 4 is a schematic cross-sectional view of a semiconductor package in accordance with some embodiments of the disclosure;
FIG. 5 is a schematic cross-sectional view of a semiconductor package in accordance with some embodiments of the disclosure;
FIG. 6 is a schematic cross-sectional view of a semiconductor package in accordance with some embodiments of the disclosure;
FIG. 7 is a schematic cross-sectional view of a semiconductor package in accordance with some embodiments of the disclosure;
FIG. 8 is a schematic cross-sectional view of a semiconductor package assembly including the semiconductor package of FIG. 1 in accordance with some embodiments of the disclosure;
FIG. 9 is a schematic cross-sectional view of a semiconductor package assembly including the semiconductor package of FIG. 2 in accordance with some embodiments of the disclosure;
FIG. 10 is a schematic cross-sectional view of a semiconductor package assembly including the semiconductor package of FIG. 3 in accordance with some embodiments of the disclosure;
FIG. 11 is a schematic cross-sectional view of a semiconductor package assembly including the semiconductor package of FIG. 4 in accordance with some embodiments of the disclosure;
FIG. 12 is a schematic cross-sectional view of a semiconductor package assembly including the semiconductor package of FIG. 5 in accordance with some embodiments of the disclosure;
FIG. 13 is a schematic cross-sectional view of a semiconductor package assembly including the semiconductor package of FIG. 6 in accordance with some embodiments of the disclosure;
FIG. 14 is a schematic cross-sectional view of a semiconductor package assembly including the semiconductor package of FIG. 7 in accordance with some embodiments of the disclosure;
FIG. 15 is a schematic cross-sectional view of a semiconductor package assembly including the semiconductor package of FIG. 1 in accordance with some embodiments of the disclosure;
FIG. 16 is a schematic cross-sectional view of a semiconductor package assembly including the semiconductor package of FIG. 2 in accordance with some embodiments of the disclosure;
FIG. 17 is a schematic cross-sectional view of a semiconductor package assembly including the semiconductor package of FIG. 3 in accordance with some embodiments of the disclosure;
FIG. 18 is a schematic cross-sectional view of a semiconductor package assembly including the semiconductor package of FIG. 4 in accordance with some embodiments of the disclosure;
FIG. 19 is a schematic cross-sectional view of a semiconductor package assembly including the semiconductor package of FIG. 5 in accordance with some embodiments of the disclosure;
FIG. 20 is a schematic cross-sectional view of a semiconductor package assembly including the semiconductor package of FIG. 6 in accordance with some embodiments of the disclosure; and
FIG. 21 is a schematic cross-sectional view of a semiconductor package assembly including the semiconductor package of FIG. 7 in accordance with some embodiments of the disclosure.

### DETAILED DESCRIPTION OF THE DISCLOSURE

The following description is made for the purpose of illustrating the general principles of the disclosure and should not be taken in a limiting sense. The scope of the disclosure is best determined by reference to the appended claims.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

Advanced integrated circuit (IC) devices have become increasingly multifunctional and have been scaled down in size. Although the scaling down process generally increases production efficiency and lowers the associated costs, it has also increased the complexity of processing and manufacturing IC devices. For example, back-side power delivery network (BSPDN) technology is adopted to decrease the coupling of signal I/O (input/output) and power/ground in the front-side routing, so as to decrease back end of line (BEOL) capacitance and IR drop, thereby improving performance of IC. Although existing integrated circuit (IC) devices are generally adequate, they are not satisfactory in every respect. For example, the direction of signals goes downward competing with BSPDN on the area in the back-side (in the illustration of the present disclosure, the direction is downward) of a chip, which also happens in the current front-side power delivery network (FSPDN). In addition, contention and competition among signal integrity (SI), power integrity (PI) and thermal conduction in BSPDN at the back-side of a chip result in potential degradation for both SI and PI in the chip, package, and printed circuit board (PCB). Furthermore, when signal routings stay in the front-side of a chip with BSPDN taking priority facing down to the PCB side, SI can easily be degraded. Therefore, there is a need to further improve semiconductor packages to provide an improved design of signaling in BSPDN.

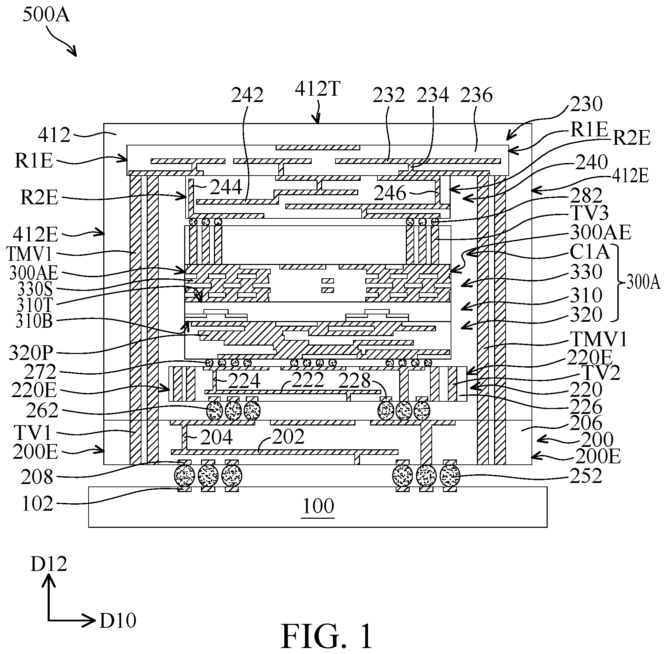

FIG. 1 is a schematic cross-sectional view of a semiconductor package 500A in accordance with some embodiments of the disclosure. In some embodiments, the semiconductor package can be used to form a fan-out package, a two-dimensional (2D) package, a 2.5D package, a three-dimensional (3D) semiconductor package, or another suitable package. In this embodiment, the semiconductor package 500A is a single fan-out chip package. The semiconductor package 500A may be mounted on and coupled to a base 100. In some embodiments, the semiconductor package 500A includes a fan-out package such as a system-on-chip (SOC) package. In some embodiments, the semiconductor package 500A may not include the base 100; that is, the base 100 is external to the semiconductor package 500A. In FIG. 1 and the following figures, directions D10 and D12 are defined as horizontal directions (also regarded as the extending directions of conductive layers and/or conductive traces of the semiconductor package 500A), and the direction D12 is defined as a vertical direction (also regarded as the extending direction of the through via and/or vias of the semiconductor package 500A).

As shown in FIG. 1, the base 100, for example a printed circuit board (PCB), may be formed of polypropylene (PP), Pre-preg, FR-4 and/or other epoxy laminate material. It should also be noted that the base 100 can be a single layer or a multilayer structure. A plurality of pads 102 and/or conductive traces (not shown) is disposed on the base 100. In one embodiment, the conductive traces may comprise signal trace segments or ground trace segments, which are used for the input/output (I/O) connections of the semiconductor package 500A. Also, the semiconductor package 500A is mounted directly on the conductive traces. In some other embodiments, the pads 102 are connected to different terminals of the conductive traces. The pads 102 are used for the semiconductor package 500A that is mounted directly on them.

As shown in FIG. 1, the semiconductor package 500A is mounted on the base 100 by a bonding and/or reflow process. The semiconductor package 500A is mounted on the base 100 using conductive structures 252. In some embodiments, the semiconductor package 500A is a fan-out semiconductor package including a first interconnect structure 200, a first chip 300A, a first redistribution layer 230, a molding compound 412, through mold vias (TMVs) TMV1, and conductive structures 252.

The conductive structures 252 are disposed on the first interconnect structure 200 and opposite to the first chip 300A. The conductive structures 252 are in contact with and electrically connected (or coupled) to the first interconnect structure 200. In addition, the conductive structures 252 are electrically connected (or coupled) to the pads 102 of the base 100. In some embodiments, the conductive structures 252 include a conductive ball structure such as a solder ball, or a conductive structure such as a copper bump or a solder bump structure. For example, the conductive structures 252 may be controlled collapse chip connection (C4) structures. In some embodiments, each of the conductive structures 252 may include an under bump metallurgy (UBM) layer and a conductive ball structure on the under bump metallurgy (UBM) layer.

In some embodiments, the first interconnect structure 200 includes a substrate, a redistribution layer (RDL) or an interposer. In some embodiments, the interposer includes a glass interposer, a semiconductor (e.g., silicon) interposer or an organic interposer. In some embodiments, the first interconnect structure 200 includes one or more conductive traces 202, one or more vias 204 disposed in one or more dielectric layers 206, and contact pads 208.

In some embodiments, the first interconnect structure 200 further includes through vias (TVs) TV1 pass through the first interconnect structure 200. As shown in FIG. 1, the through vias TV1 may be positioned near the edges 200E of the first interconnect structure 200, or alternatively, they may be positioned away from the edges 200E of the first interconnect structure 200. In a cross-sectional view as shown in FIG. 1, The conductive traces 202, the vias 204 and the contact pads 208 are disposed between the through vias TV1 close to opposite edges 200E of the first interconnect structure 200.

In some embodiments, the conductive traces 202, the vias 204, the contact pads 208 and the through vias TV1 include a conductive material, such as metals comprising copper, gold, silver, or other applicable metals. The dielectric layers 206 may include extra-low K (ELK) dielectrics and/or ultra-low K (ULK) dielectric. It should be noted that the number of conductive traces 202, the number of vias 204, the number of contact pad 208, the number of through vias TV1 and the number of dielectric layers 206 shown in FIG. 1 are only an example and is not a limitation to the present disclosure.

In some embodiments, the semiconductor package 500A further includes a second interconnect structure 220 located between the first interconnect structure 200 and the first chip 300A. The second interconnect structure 220 is mounted on and coupled to the first interconnect structure 200 by a bonding process using conductive structures 262. The conductive structures 252 and 262 may have the same or similar structure (e.g., conductive ball structures or a conductive bumps). For example, the conductive structures 262 may include solder balls or microbumps. In addition, the size (e.g., the diameter) of the conductive structures 262 may be smaller than the conductive structures using the conductive structures 252.

The second interconnect structure 220 may partially cover the first interconnect structure 200 in the direction D12. In addition, edges 220E of the second interconnect structure 220 are not level with the corresponding edges 200E of the first interconnect structure 200.

The first interconnect structure 210 and the second interconnect structure 220 may have the same or similar structure. In some embodiments, the second interconnect structure 220 includes a substrate, a redistribution layer (RDL) or an interposer. In some embodiments, the second interconnect structure 220 includes one or more conductive traces 222, one or more vias 224 disposed in one or more dielectric layers 226, contact pads 228 and through vias TV2. In some embodiments, the first interconnect structure 200 may be a substrate, and the second interconnect structure 220 may be an interposer. This configuration enhances the routing flexibility and connection robustness of the semiconductor package.

In some embodiments, the material of the conductive traces 222, the vias 224, the contact pads 228 and the through vias TV2 of the second interconnect structure 220 may be the same or similar to the material of the conductive traces 202, the vias 204, the contact pads 208 and the through vias TV1 of the first interconnect structure 200. In some embodiments, the material of the dielectric layers 226 of the second interconnect structure 220 may be the same or similar to the material of the dielectric layers 206 of the first interconnect structure 200. In some embodiments, the size (e.g., the line width of the conductive traces, the diameter of the through vias, or the dimension of the contact pads) of the conductive traces 222, the vias 224, the contact pads 228 and the through vias TV2 of the second interconnect structure 220 may be smaller than the size of the conductive traces 202, the vias 204, the contact pads 208 and the through vias TV1 of the first interconnect structure 200.

It should be noted that the number of conductive traces 222, the number of vias 224, the number of contact pad 228, the number of through vias TV2 and the number of dielectric layers 226 shown in FIG. 1 are only an example and is not a limitation to the present disclosure.

The first chip 300A is arranged over/on the first interconnect structure 200 and the second interconnect structure 220. The first chip 300A is mounted on and coupled to the second interconnect structure 220 by a bonding process using conductive structures 272. The conductive structures 262 and 272 may have the same or similar structure (e.g., conductive bumps). For example, the conductive structures 272 may include microbumps. In addition, the size (e.g., the diameter) of the conductive structures 272 may be smaller than the conductive structures 262. In addition, the first chip 300A is coupled to the first interconnect structure 200 through the second interconnect structure 220 and the conductive structures 262, 272.

In some embodiments, the first chip 300A includes a system-on-chip (SoC) die, a logic device, a memory device, a radio frequency (RF) device, the like, or any combination thereof. For example, the first chip 300A may include a micro control unit (MCU) die, a microprocessor unit (MPU) die, a power management integrated circuit (PMIC) die, a radio frequency front end (RFFE) die, an accelerated processing unit (APU) die, a central processing unit (CPU) die, a graphics processing unit (GPU) die, an input-output (IO) die, a dynamic random access memory (DRAM) controller, a static random-access memory (SRAM), a high bandwidth memory (HBM), an application processor (AP) die, an application specific integrated circuit (ASIC) die, the like, or any combination thereof.

In some embodiments, the first chip 300A is applied in the back-side power technology and may be fabricated by semiconductor nodes, such as the gate-all-around (GAA) processes and etc. In some embodiments, the first chip 300A includes a first back-side connect structure 320, a first transistor layer 310, a first front-side connect structure 330 and a first carrier C1A, from bottom to top.

The first transistor layer 310 includes a semiconductor substrate (not shown) and at least one transistor (not shown) formed on the semiconductor substrate. In some other embodiments, the first transistor layer 310 may include other active components or passive components formed on the semiconductor substrate.

The first back-side connect structure 320 is formed on a back surface 310B of the first transistor layer 310. In other words, the first transistor layer 310 is located on the first back-side connect structure 320. The first back-side connect structure 320 is connected to and couple to the first interconnect structure 200 through the second interconnect structure 220 and the conductive structures 262, 272. The first back-side connect structure 320 is connected to and couple to the first transistor layer 310 by TVs (not shown) passing through the semiconductor substrate.

In some embodiments, the first back-side connect structure 320 may include multiple dielectric layers and conductive routings (including power routings and ground routings) formed in the multiple dielectric layers. The conductive routings including conductive lines and vias (not shown) may be formed of copper or copper alloys, and may be formed using one or more damascene processes. The dielectric layers may include inter-layer dielectric (ILD) layers and inter-metal dielectric (IMD) layers.

In some embodiments, the first back-side connect structure 320 is used for connecting to a power supply (not shown) and/or a ground (not shown). Alternatively, the first back-side connect structure 320 is used for connecting to a power supply (not shown) and/or a ground (not shown) and is also used for signal transmission. For example, the first back-side connect structure 320 may include power routings (e.g., power routings 320P) and ground routings (not shown). Alternatively, the first back-side connect structure 320 may include power routings (e.g., power routings 320P), ground routings (not shown) and signal routings (not shown).

The first front-side connect structure 330 is located on a front surface 310T of the first transistor layer 310 and opposite the first back-side connect structure 320. The first front-side connect structure 330 is separated from the first back-side connect structure 320 by the first transistor layer 310.

In some embodiments, the first front-side connect structure 330 may be similar to the first back-side connect structure 320 and includes multiple dielectric layers and conductive routings formed in the multiple dielectric layers. The number of dielectric layers in the first front-side connect structure 330 and the first back-side connect structure 320 may be the same or may be different.

In some embodiments, the first front-side connect structure 330 may include signal routings 330S only. The signal routings 330S are configured to transmit data signals, control signals, and other user signals.

As shown in FIG. 1, the first carrier C1A is located on and coupled to the first front-side connect structure 330. In addition, the first carrier C1A and the first transistor layer 310 are in contact with opposite sides of the first front-side connect structure 330. In some embodiments, the first carrier C1A is a silicon wafer carrier. In some embodiments, the first carrier C1A includes through vias (TVs) TV3 passing through the first carrier C1A and connected between the first front-side connect structure 330 and the first RDL 230.

As shown in FIG. 1, the first RDL 230 is arranged over/on and coupled to the first chip 300A. In some embodiments, the first interconnect structure 200, the second interconnect structure 220 and the first RDL 230 may have the same or similar structure.

The first RDL 230 may partially or completely cover the first interconnect structure 200, the second interconnect structure 220 and the first chip 300A in the direction D12. In some embodiments in which the first RDL 230 partially covers the first interconnect structure 200, edges R1E of the first RDL 230 are not level with the corresponding edges 200E of the first interconnect structure 200. In some embodiments in which the first RDL 230 completely covers the first interconnect structure 200, edges R1E of the first RDL 230 are level with the corresponding edges 200E of the first interconnect structure 200.

In some embodiments, the first RDL 230 includes one or more conductive traces 232 and one or more vias 234 disposed in one or more dielectric layers 236.

In some embodiments, the material of the conductive traces 232 and the vias 234 of the first RDL 230 may be the same or similar to the material of the conductive traces 202, the vias 204, the contact pads 208 and the through vias TV1 of the first interconnect structure 200 and the conductive traces 222, the vias 224, the contact pads 228 and the through vias TV2 of the second interconnect structure 220. In some embodiments, the material of the dielectric layers 236 of the first RDL 230 may be the same or similar to the material of the dielectric layers 206 of the first interconnect structure 200 and the dielectric layers 226 of the second interconnect structure 220. It should be noted that the number of conductive traces 232, the number of vias 234 and the number of dielectric layers 236 shown in FIG. 1 are only an example and is not a limitation to the present disclosure.

As shown in FIG. 1, the first back-side connect structure 320 of the first chip 300A of the semiconductor package 500A is located close to the first interconnect structure 200, and the first carrier C1A of the first chip 300A of the semiconductor package 500A is located close to and coupled to the first RDL 230.

Optionally, the semiconductor package 500A may further include a second RDL 240 arranged between the first carrier C1A and the first RDL 230 in the direction D12. Optionally, the second RDL 240 may be mounted on the first carrier C1A by a bonding process using conductive structures 282. In some embodiments, the conductive structures 272 and 282 may have the same or similar structure (e.g., conductive bumps) and size (e.g., the diameter). For example, the conductive structures 272 may include microbumps. Alternatively, the conductive structures 282 may include conductive pads.

In some embodiments, the second RDL 240 includes one or more conductive traces 242 and one or more vias 244 disposed in one or more dielectric layers 246.

In some embodiments, the material of the conductive traces 242 and the vias 244 of the second RDL 240 may be the same or similar to the material of the conductive traces 202, the vias 204, the contact pads 208 and the through vias TV1 of the first interconnect structure 200 and the conductive traces 222, the vias 224, the contact pads 228 and the through vias TV2 of the second interconnect structure 220, and the conductive traces 232 and the vias 234 of the first RDL 230. In some embodiments, the material of the dielectric layers 246 of the second RDL 240 may be the same or similar to the material of the dielectric layers 206 of the first interconnect structure 200 and the dielectric layers 226 of the second interconnect structure 220, and the dielectric layers 236 of the first RDL 230. It should be noted that the number of conductive traces 242, the number of vias 244 and the number of dielectric layers 246 shown in FIG. 1 are only an example and is not a limitation to the present disclosure.

In some embodiments, edges R2E of the second RDL 240 are not level with the corresponding edges R2E of the first RDL 230. In some embodiments, edges R2E of the second RDL 240 may be level with the corresponding edges 300AE of the first chip 300A or the corresponding edges 220E of the second interconnect structure 220.

The molding compound 412 is arranged on the first interconnect structure 200 and encapsulating the first chip 300A and the first RDL 230. As shown in FIG. 1, the molding compound 412 is disposed on the first interconnect structure 200. In addition, the molding compound 412 surrounds and is in contact with the first chip 300A, the second interconnect structure 220 and the optional second RDL 240. The edges 200E of the first interconnect structure 200 may be exposed from the molding compound 412. In some embodiments, the top surface 412T of the molding compound 412 may form the top surface of the semiconductor package 500A. Edges 412E of the molding compound 412 may form edges of the semiconductor package 500A.

In some embodiments, the molding compound 412 may be formed of a nonconductive material, such as an epoxy, a resin, a moldable polymer, or the like. The molding compound 412 may be applied while substantially liquid, and then may be cured through a chemical reaction, such as in an epoxy or resin. In some other embodiments, the molding compound 412 may be an ultraviolet (UV) or thermally cured polymer applied as a gel or malleable solid capable of being disposed around the first chip 300A, the second interconnect structure 220, the first RDL 230 and the optional second RDL 240, and then may be cured using a UV or thermally curing process. The molding compound 412 may be cured with a mold (not shown).

As shown in FIG. 1, the through mold vias (TMVs) TMV1 pass through the molding compound 412 between the first RDL 230 and the first interconnect structure 200. In addition, the through mold vias TMV1 are connected and coupled between the first RDL 230 and the first interconnect structure 200. For example, opposite terminals of the through mold vias TMV1 are couple to the through vias TV1 of the first interconnect structure 200 and the conductive traces 232 of the first interconnect structure 200.

In some embodiments, the through mold vias TMV1 are arranged close to the edges (e.g., the edges 412E) of the semiconductor package 500A. For example, the through mold vias TMV1 may surround the first chip 300A, the second interconnect structure 220 and the optional second RDL 240.

In this embodiment, the through mold vias TMV1 may serve as signaling through mold vias, which are used to transmit data signals, control signals, and other user signals of the first chip 300A.

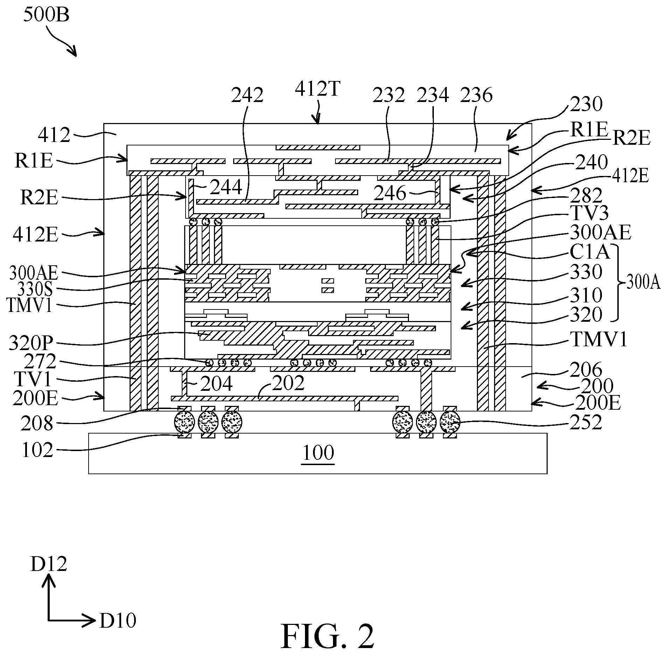

FIG. 2 is a schematic cross-sectional view of a semiconductor package 500B in accordance with some embodiments of the disclosure. Elements of the embodiments that are the same or similar to those previously described with reference to FIG. 1 are not repeated herein, in the interests of brevity. As shown in FIGS. 1 and 2, the difference between the semiconductor package 500A and the semiconductor package 500B at least includes that a first chip 300A of the semiconductor package 500B is arranged over/on the first interconnect structure 200 without the second interconnect structure 220 (FIG. 1) disposed between the first chip 300A and the first interconnect structure 200.

As shown in FIG. 2, the conductive structures 272 of the semiconductor package 500B are directly connected (or coupled) between and in contact with the first chip 300A and the first interconnect structure 200. The packaging structure of semiconductor package 500B can be chip-substrate-PCB (e.g., the first chip 300A is disposed on first interconnect structure 200 disposed on the base 100).

The semiconductor packages 500A and 500B have the following advantages. In the semiconductor packages 500A and 500B, the first chip 300A having back-side power delivery network (BSPDN) (e.g., the back-side connect structure 320) may arrange signal in the front-side (FS) back end of line (BEOL) (e.g., the front-side connect structure 330) separated from and power and ground routings the back-side (BS) in the BSPDN (e.g., the back-side connect structure 320). The signal routings may be coupled to the first RDL 230 using wired communication (including the through vias (e.g., the through vias TV1, TV2), the redistribution layers (e.g., the first RDL 230 and the second RDL 240), and the through molding vias (e.g., the through molding vias TMV1) in epoxy molding compound (EMC) (e.g., the molding compound 412) and fan out wafer/panel level package (FOW/PLP) (e.g., the semiconductor packages 500A and 500B).

In some embodiments, the package structure of the semiconductor package 500A can be chip-interposer-substrate-PCB structure (e.g., the first chip 300A disposed on the second interconnect structure 220 disposed on the first interconnect structure 200 disposed on the base 100). The package structure of the semiconductor package 500B can be chip-substrate-PCB structure (e.g., the first chip 300A disposed on the first interconnect structure 200 disposed on the base 100).

Compared with the signal input/output (I/O) in the conventional front-side power delivery network (FSPDN), signal integrity (SI) in the FS-BEOL of the first chips 300A of the semiconductor packages 500A and 500B can be relaxed as signals fully decouple from power/ground and directly input/output upward to FOW/PLP-level and multi-layer RDL (e.g., the first RDL 230 and the second RDL 240) and TMVs (e.g., the through molding vias TMV1), which are scaled up in width, thickness, and gaps, and as signals are not proximal to power rails.

In the semiconductor packages 500A and 500B, power integrity (PI) in BS (e.g., the back-side connect structure 320) of the first chips 300A of the semiconductor packages 500A and 500B can be relaxed as all the area and layers are dedicated for power and ground rails in the BSPDN (e.g., the back-side connect structure 320), reducing isolation design and congestions for signals, optimizing inductance and PI, and increasing power delivery design flexibility.

In the semiconductor packages 500A and 500B, the FS-BEOL (e.g., the front-side connect structure 330) of the first chip 300A facing upward allows 3D stacking with another BSPDN chip with its FS facing downward. Alternatively, the semiconductor packages 500A and 500B may allow multiple BSPDN chips stacked on each other with FS-to-FS, the FS-to-BS, BS-to-BS configurations.

In the semiconductor packages 500A and 500B, the back-side (BS) (e.g., the back-side connect structure 320) of the first chip 300A may be used purely for power transmission and grounding, and the front-side (FS) (e.g., the front-side connect structure 330) may be used purely for signal transmission, thereby decoupling thick power/ground wires (e.g., the power routings 320P) from thin signaling wires (e.g., the signal routings 330S). Alternatively, the BS of the first chip 300A can also be used for power transmission, grounding and signal transmission, while the FS of the first chip 300A is only used for signal transmission.

In some embodiments, the semiconductor packages 500A and 500B having through vias (e.g., the through vias TV3) in the carrier (e.g., the first carrier C1A), I/Os (e.g., the conductive structures 282) of the first chip 300A dedicated for signaling are revealed on top of the carrier. The back-side connect structure (e.g., the back-side connect structure 320) is used for connecting to a power supply and/or ground and can also be used for signal transmission. The front-side connect structure (e.g., the front-side connect structure 330) is only used for signal transmission.

In the semiconductor packages 500A and 500B, I/Os (e.g., the conductive structures 282) of the first chip 300A that support upward signaling may be in the form of pads or bumps depend on whether a chip-first or chip-last process is used, and on the number of FOW or PLP units.

Compared with the pure silicon carrier, the through vias (e.g., the through vias TV3) in the carrier (e.g., the first carrier C1A) of the semiconductor packages 500A and 500B may increase the effective thermal conductivity of the chip (e.g., the first chip 300A), thereby increasing thermal performance of the semiconductor packages 500A and 500B.

In the semiconductor packages 500A and 500B, the bump pitch (e.g., the pitch of the conductive structures 272 and 282) of the chip (e.g., the first chip 300A) can be relaxed since the top and bottom side of the chip are leveraged for signal I/Os and power/ground (P/G), not one side of the chip alone.

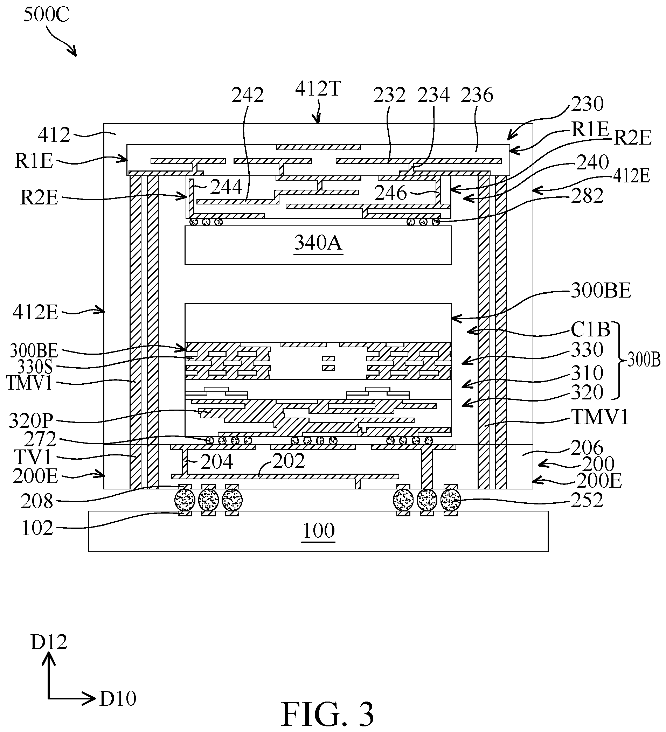

FIG. 3 is a schematic cross-sectional view of a semiconductor package 500C in accordance with some embodiments of the disclosure. Elements of the embodiments that are the same or similar to those previously described with reference to FIG. 1 are not repeated herein, in the interests of brevity. As shown in FIGS. 1 and 2, the difference between the semiconductor package 500B and the semiconductor package 500C at least includes that the semiconductor package 500C further includes a second chip 340A.

As shown in FIG. 3, the second chip 340A of the semiconductor package 500C is arranged over/on the first chip 300B. The second chip 340A is spaced apart from the first chip 300B by a molding compound 412. The first redistribution layer (RDL) 230 is arranged over/on and coupled to the second chip 340A. The molding compound 412 is arranged on the first interconnect structure 200 and encapsulating the first chip 300B, the second chip 340A and the first RDL 230.

Optionally, the semiconductor package 500B may further include a second RDL 240 arranged between the second chip 340A and the first RDL 230 in the direction D12. Optionally, the second RDL 240 may be directly arranged on the second chip 340A without using conductive structures, such as solder balls.

In some embodiments, the first chip 300B applied in the back-side power technology includes a first back-side connect structure 320, a first transistor layer 310, a first front-side connect structure 330 and a first carrier C1B, from bottom to top.

In some embodiments, the second chip 340A includes a transceiver chip. Alternatively, the second chip 340A includes a logic chip, a memory chip, a radio frequency (RF) chip or/and analog chip having a transceiver function.

In some embodiments, the second chip 340A and the first chip 300B are coupled to each other by near-field coupling. Near-field coupling may include electrical coupling, magnetic coupling and/or electromagnetic coupling. Since the first chip 300B are coupled to the second chip 340A by near-field coupling, the first carrier C1B of the first chip 300B can be formed without through vias (TVs) formed through it.

As shown in FIG. 3, the through mold vias TMV1 are coupled between the first RDL 230 and the first interconnect structure 200. In addition, the through mold vias TMV1 may surround the first chip 300A, the second chip 340A, and the optional second chip 340A. In this embodiment, the through mold vias TMV1 may serve as signaling through mold vias, which are used to transmit data signals, control signals, and other user signals from the first chip 300B and coupled to the second chip 340A. In some embodiments, the back-side (BS) (e.g., the back-side connect structure 320) of the first chip 300B may be used purely for power transmission and grounding, while the front-side (FS) (e.g., the front-side connect structure 330) may be used purely for signal transmission, thereby decoupling thick power/ground wires (e.g., the power routings 320P) from thin signaling wires (e.g., the signal routings 330S). The signal can be transmitted to the second chip 340A through the front-side connect structure 330, then via near-field coupling, and subsequently transmitted to other components through the second RDL 240, the first RDL 230, the through-mold vias (TMV1), and other pathways. The power and ground connections of the second chip 340A can also be routed through the second RDL 240, the first RDL 230, and the through-mold vias (TMV1), among others. In some embodiments, the BS of the first chip 300B can also be used for power transmission, grounding, and signal transmission, while the FS of the first chip 300B is only used for signal transmission. The signal can be transmitted to the second chip 340A through the front-side connect structure 330, then via near-field coupling, and subsequently transmitted to other components through the second RDL 240, the first RDL 230, the through-mold vias (TMV1), and other pathways. The power and ground connections of the second chip 340A can also be routed through the second RDL 240, the first RDL 230, and the through-mold vias (TMV1), among others.

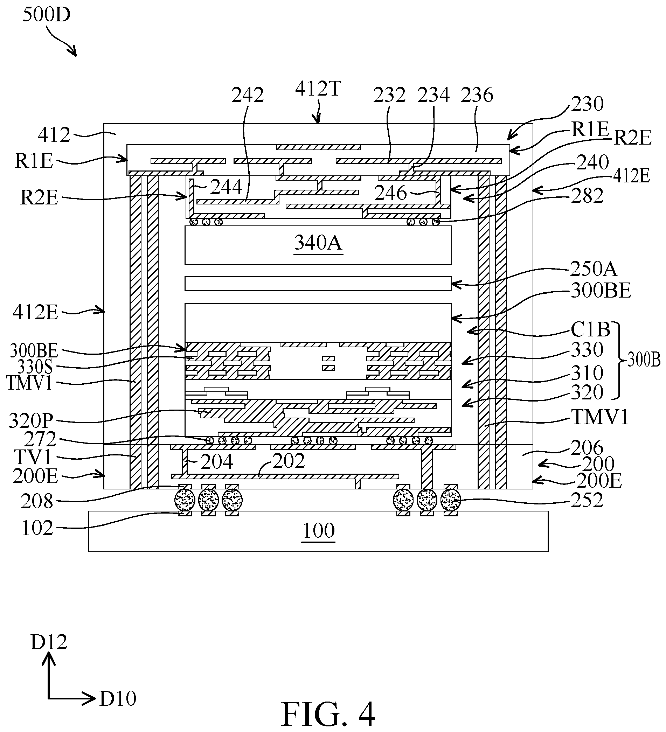

FIG. 4 is a schematic cross-sectional view of a semiconductor package 500D in accordance with some embodiments of the disclosure. Elements of the embodiments that are the same or similar to those previously described with reference to FIGS. 1 to 3 are not repeated herein, in the interests of brevity. As shown in FIGS. 3 and 4, the difference between the semiconductor package 500C and the semiconductor package 500D at least includes that the semiconductor package 500D further includes a thermal interface material (TIM) 250A.

As shown in FIG. 4, the second chip 340A spaced apart from the first chip 300B by a molding compound 412 and the thermal interface material (TIM) 250A. The TIM 250A is disposed between the first chip 300B and the second chip 340A in the direction D12 to improve thermal dissipation efficiency. In addition, the TIM 250A is surrounded by the molding compound 412.

In some embodiments, the TIM 250A may include a metal or a metal alloy including Al, Cu, Ni, Co. In some embodiments, the design of the TIM 250A (including its material selection, thickness, and positioning) must be co-optimized (co-designed) with the transceiver chip(s) (e.g., the second chip 340A) to ensure the normal operation of the transceiver chip(s) and to guarantee stable data transmission. In addition, the TIM 250A may include diamond, aluminum nitride, boron nitride, etc., or other high thermal conductivity material. In some embodiments, the TIM 250A may be made of a non-metallic material, such as a polymer. This non-metallic TIM has a higher thermal conductivity than the molding compound 412, enabling faster heat dissipation.

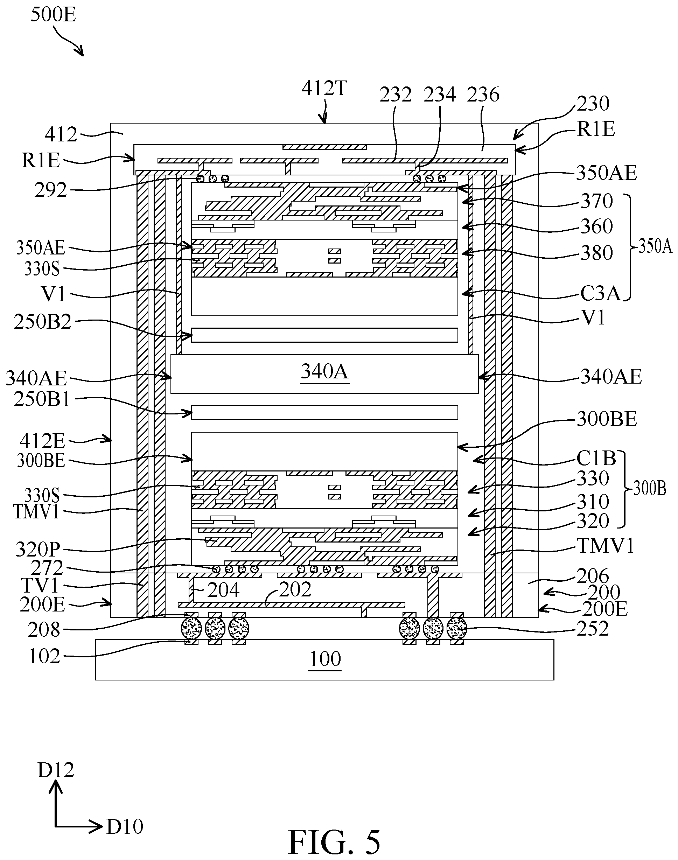

FIG. 5 is a schematic cross-sectional view of a semiconductor package 500E in accordance with some embodiments of the disclosure. Elements of the embodiments that are the same or similar to those previously described with reference to FIGS. 1 to 4 are not repeated herein, in the interests of brevity. As shown in FIG. 5, the semiconductor package 500D includes a first interconnect structure 200, a first chip 300B, a second chip 340A, a third chip 350A, a first redistribution layer 230, a molding compound 412, through mold vias (TMVs) TMV1, conductive structures 252, 272 and 292, and vias V1. The first interconnect structure 200, the first chip 300B, the second chip 340A, the first redistribution layer 230, the molding compound 412, the through mold vias (TMVs) TMV1, and conductive structures 252, 272 are the same or similar to those in the previously described semiconductor packages 500A to 500D with reference to FIGS. 1 to 4, and they are not repeated herein, in the interests of brevity.

As shown in FIG. 5, the third chip 350A is flipped and arranged over/on the second chip 340A. The third chip 350A is spaced apart from the first chip 300B by the molding compound 412 and thermal interface materials (TIM) 250B1 and 250B2. More specifically, the first chip 300B is spaced apart from the second chip 340A by the molding compound 412 and the thermal interface materials (TIM) 250B1, and the third chip 350A is spaced apart from the second chip 340A by the molding compound 412 and thermal interface materials (TIM) 250B2. Furthermore, the third chip 350A is mounted on and coupled to the first RDL 230 by a bonding process using conductive structures 292. The conductive structures 272 and 292 may have the same or similar structure and size (e.g., the diameter).

In some embodiments, the third chip 350A and the second chip 340A are coupled each other by near-field coupling. Near-field coupling may include electrical coupling, magnetic coupling and/or electromagnetic coupling.

In some embodiments, the third chip 350A includes a system-on-chip (SoC) die, a logic device, a memory device, a radio frequency (RF) device, the like, or any combination thereof. For example, the first semiconductor die 128 and the second semiconductor die 138 may each include a micro control unit (MCU) die, a microprocessor unit (MPU) die, a power management integrated circuit (PMIC) die, a radio frequency front end (RFFE) die, an accelerated processing unit (APU) die, a central processing unit (CPU) die, a graphics processing unit (GPU) die, an input-output (IO) die, a dynamic random access memory (DRAM) controller, a static random-access memory (SRAM), a high bandwidth memory (HBM), an application processor (AP) die, an application specific integrated circuit (ASIC) die, the like, or any combination thereof.

The first chip 300B and the third chip 350A may include the same or different devices. For example, the first chip 300A and the third chip 350A may include SoC dies. Alternatively, the first chip 300A may include a SoC die, and the third chip 350A may include a HBM die. It should be noted that three semiconductor dies are for illustrative purposes only, more than three semiconductor dies and/or one or more passive components (such as resistors, capacitors, or inductors) may be disposed over/on the first redistribution layer 230 and/or the first RDL 230.

Similar to the first chip 300B, the third chip 350A is also applied in the back-side power technology and fabricated by the gate-all-around (GAA) processes. The third chip 350A includes a third back-side connect structure 370, a third transistor layer 360, a third front-side connect structure 380 and a third carrier C3A, from top to bottom.

The third back-side connect structure 370 is connected to the first RDL 230. The third transistor layer 360 is located on the back-side connect structure 370. In addition, the third front-side connect structure 380 is located on the third transistor layer 360. Furthermore, the third carrier C3A is located on the third front-side connect structure 380.

In some embodiments, the first chip 300B and the third chip 350A have the same or similar structure and material. For example, the first back-side connect structure 320 and the third back-side connect structure 370 may have the same or similar structure and material. The first transistor layer 310 and the third transistor layer 360 may have the same or similar structure and material. The first front-side connect structure 330 and the third front-side connect structure 380 may have the same or similar structure and material.

In some embodiments, the third chip 350A may completely or partially cover the first chip 300B. In some embodiments in which the third chip 350A completely covers the first chip 300B, edges 300BE of the first chip 300B are level with the corresponding edges 350AE of the third chip 350A. In some embodiments in which the third chip 350A partially covers the first chip 300B, edges 300BE of the first chip 300B are not level with the corresponding edges 350AE of the third chip 350A.

In some embodiments, the third chip 350A may partially cover the second chip 340A in the direction D12. Edges 340AE of the second chip 340A are not level with the corresponding edges 330AE of the third chip 350A. According to the difference of sizes between the second chip 340A and the third chip 350A, the second chip 340A is connected and couple to the first RDL 230 by the vias V1 embedded in the molding compound 412. In some embodiments, the vias V1 may pass through a portion of the molding compound 412 located between the first RDL 230 and the second chip 340A and the first RDL 230 in the direction D12. In addition, the vias V1 may surround the first chip 300B and the thermal interface materials (TIM) 250B2.

In some embodiments, the vias V1 may serve as signaling vias, which are used to transmit data signals, control signals, and other user signals from the first chip 300B and the third chip 350A and coupled to the second chip 340A.

As shown in FIG. 5, the through mold vias TMV1 are coupled between the first RDL 230 and the first interconnect structure 200. In addition, the through mold vias TMV1 may surround the first chip 300A, the second chip 340A, the third chip 350A, the TIM 250B1 and 250B2 and the vias V1. In this embodiment, some of the through mold vias TMV1 may serve as signaling through mold vias, which are used to transmit data signals, control signals, and other user signals from the first chip 300B and the third chip 350A and coupled to the second chip 340A. Some other of the through mold vias TMV1 may also serve to transmit power to the third chip 350A.

The semiconductor packages 500C, 500D and 500E have the following advantages. In the semiconductor packages 500C, 500D and 500E, the first chip 300B (or the third chip 350A) having back-side power delivery network (BSPDN) (e.g., the back-side connect structure 320 or 370) may arrange signal routings in the front-side (FS) back end of line (BEOL) (e.g., the front-side connect structure 330 or 380) separated from the back-side (BS) power and ground routings in the BSPDN (e.g., the back-side connect structure 320 or 370). The signal routings may be coupled to the first RDL 230 using wireless communication.

In some embodiments, the package structure of the semiconductor packages 500C, 500D and 500E can be chip-substrate-PCB structure (e.g., the first chip 300B disposed on the first interconnect structure 200 disposed on the base 100).

Compared with the signal input/output (I/O) in the conventional front-side power delivery network (FSPDN), signal integrity (SI) in the FS-BEOL of the first chips 300B (or the third chip 350A) of the semiconductor packages 500C, 500D and 500E can be relaxed as signals fully decouple from power/ground and wirelessly input/output to FOW/PLP-level and multi-layer RDL (e.g., the first RDL 230) and TMVs (e.g., the through molding vias TMV1), which are scaled up in width, thickness, and gaps, and as signals are not proximal to power rails.

In the semiconductor packages 500C, 500D and 500E, power integrity (PI) in BS (e.g., the back-side connect structure 320 or 370) of the first chips 300B (or the third chip 350A) of the semiconductor packages 500C, 500D and 500E can be relaxed as all the area and layers are dedicated for power and ground rails in the BSPDN (e.g., the back-side connect structure 320 or 370), reducing isolation design and congestions for signals, optimizing inductance and PI, and increasing power delivery design flexibility.

In the semiconductor packages 500C, 500D and 500E, the near-field coupling I/O in the FS-BEOL (e.g., the front-side connect structure 330 or 380) of the first chip 300B (or the third chip 350A) do not require through vias (TVs) in the carrier (e.g., the carrier C1B or C3A) to reveal signal I/Os.

In the semiconductor packages 500C, 500D and 500E, the near-field coupling between the second chip 340A and the first chip 300B of each of the semiconductor packages 500C, 500D and 500E and between the second chip 340A and the third chip 350A of the semiconductor package 500E includes electrical (e.g., capacitive) coupling, magnetic (e.g., inductive) coupling or electromagnetic (e.g., radiation) coupling.

In the semiconductor packages 500C and 500D, the transceiver (TRX) Si chip (e.g., the second chip 340A) is packaged on top of the (e.g., the carrier C1B or C3A) of the first chip 300B (or the third chip 350A) with an EMC (e.g., the molding compound 412) or a thermal interface material (TIM) (e.g., the TIM 250A) filling the gap between the TRX Si chip and the carrier.

In the semiconductor packages 500C, 500D and 500E, the TRX Si chip (e.g., the second chip 340A) may include a dedicated TRX silicon (or other semiconductor materials) bridge chip. Alternatively, the TRX Si chip may include a logic chip, a memory chip, a radio frequency (RF) chip or/and analog chip having a transceiver function.

When the TRX Si chip (e.g., the second chip 340A) include a logic chip, a memory chip, a radio frequency (RF) chip or/and analog chip having a transceiver function, the TRX Si chip can transmit and receive coupling more signals than a single chip with or without BSPDN.

When the TRX Si chip (e.g., the second chip 340A) include a logic chip, a memory chip, a radio frequency (RF) chip or/and analog chip having a transceiver function, the TRX Si chip may help lateral spread of heat inside the EMC (e.g., the molding compound 412).

In the semiconductor package 500E, the 3D stacked BSPDN chips (e.g., the first chip 300B and the third chip 350A) is disposed in the EMC (e.g., the molding compound 412) with FS-BEOL (e.g., the front-side connect structure 330) and coupled to the TRX Si chip (e.g., the second chip 340A). The TRX Si chip may act as a centralized signal collector and output.

In the semiconductor packages 500C, 500D and 500E, the back-side (BS) (e.g., the back-side connect structure 320 or 370) of the first chip 300B (or the third chip 350A) may be used for power and/or ground, and may be also used for signal transmission, while the FS-BEOL (e.g., the front-side connect structure 330 or 380) of the first chip 300B (or the third chip 350A) is only used for signal transmission.

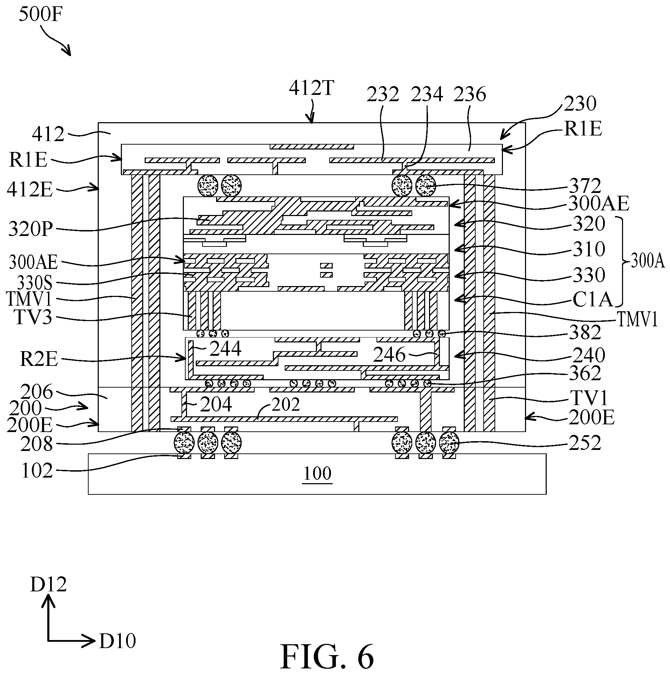

FIG. 6 is a schematic cross-sectional view of a semiconductor package 500F in accordance with some embodiments of the disclosure. Elements of the embodiments that are the same or similar to those previously described with reference to FIGS. 1 to 5 are not repeated herein, in the interests of brevity. As shown in FIGS. 2 and 6, the difference between the semiconductor package 500B and the semiconductor package 500F at least includes that a composite structure including the first chip 300A and the optional second RDL 240 mounted on the first chip 300A is flipped upside down and disposed between the first interconnect structure 200 and the first RDL 230.

In the semiconductor package 500F, the first chip 300A is connected and coupled to the first RDL 230 by conductive structures 372. The conductive structures 272 (FIG. 2) and 372 may have the same or similar structure. In addition, the size (e.g., the diameter) of the conductive structures 372 may be smaller than or equal to the conductive structures 262.

As shown in FIG. 6, the first chip 300A include a first carrier C1A, a first front-side connect structure 330, a first transistor layer 310 and a first back-side connect structure 320, from bottom to top. In this embodiment, the first carrier C1A of the first chip 300A is located close to the first interconnect structure 200. The first back-side connect structure 320 of the first chip 300A is located close to and coupled to the first RDL 230, so that the conductive structures 372 are connected and coupled between the first back-side connect structure 320 of the first chip 300A and the first RDL 230. In some embodiments, the first carrier C1A includes through vias (TVs) TV3 passing through the first carrier C1A and connected between the first front-side connect structure 330 and the first interconnect structure 200 for signal transmission of the first chip 300A.

As shown in FIG. 6, the semiconductor package 500A may optionally include a second RDL 240 arranged between the first carrier C1A of the first chip 300A and the first interconnect structure 200 in the direction D12. The second RDL 240 is mounted on and coupled to the first interconnect structure 200 by a bonding process using conductive structures 362. The conductive structures 282 and 362 may have the same or similar structure. In addition, the size (e.g., the diameter) of the conductive structures 362 may be smaller than or equal to the conductive structures 372.

As shown in FIG. 6, the first chip 300A may be optionally mounted on the second RDL 240 by a bonding process using conductive structures 382. In some embodiments, the conductive structures 362 and 382 may have the same or similar structure and size (e.g., the diameter). For example, the conductive structures 382 may include conductive bumps or conductive pads.

As shown in FIG. 6, the through mold vias TMV1 are coupled between the first RDL 230 and the first interconnect structure 200. In addition, the through mold vias TMV 1 may surround the first chip 300A and the optional second RDL 240. In this embodiment, the through mold vias TMV1 may serve as through-mold vias (TMVs) for power delivery, which are used to transmit power to the first chip 300A.

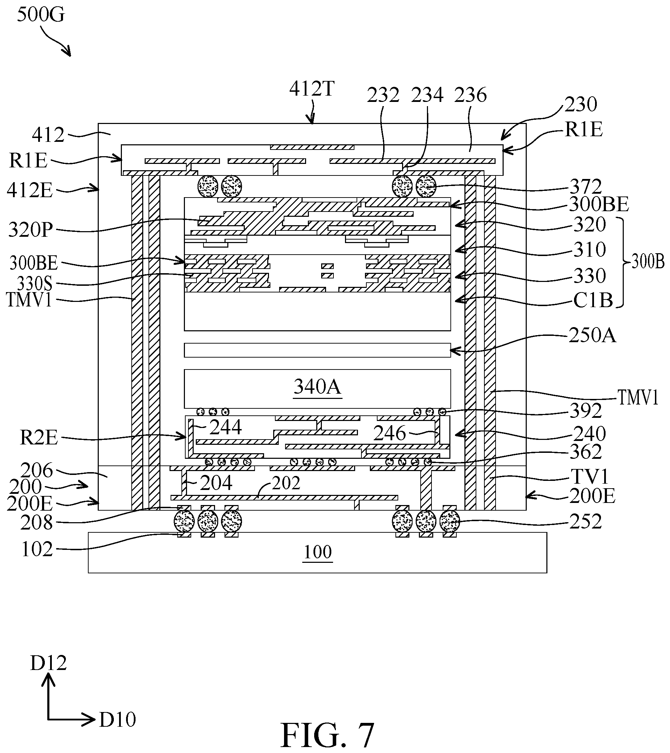

FIG. 7 is a schematic cross-sectional view of a semiconductor package 500G in accordance with some embodiments of the disclosure. Elements of the embodiments that are the same or similar to those previously described with reference to FIGS. 1 to 5 are not repeated herein, in the interests of brevity. As shown in FIGS. 4 and 7, the difference between the semiconductor package 500D and the semiconductor package 500G at least includes that a composite structure including the first chip 300B, the second chip 340A, the thermal interface material (TIM) 250A and the optional second RDL 240 is flipped upside down and disposed between the first interconnect structure 200 and the first RDL 230.

In the semiconductor package 500G, the first chip 300B is connected and coupled to the first RDL 230 by conductive structures 372. The conductive structures 272 (FIG. 4) and 372 may have the same or similar structure. In addition, the size (e.g., the diameter) of the conductive structures 372 may be smaller than or equal to the conductive structures 262.

As shown in FIG. 7, the first chip 300B include a first carrier C1B, a first front-side connect structure 330, a first transistor layer 310 and a first back-side connect structure 320, from bottom to top. In this embodiment, the first carrier C1B of the first chip 300B is located close to the first interconnect structure 200. The first back-side connect structure 320 of the first chip 300B is located close to and coupled to the first RDL 230, so that the conductive structures 372 are connected and coupled between the first back-side connect structure 320 of the first chip 300B and the first RDL 230.

As shown in FIG. 7, the second chip 340A of the semiconductor package 500G is arranged between the first interconnect structure 200 and the first chip 300B. In addition, the first carrier C1B of the first chip 300B located above the second chip 340A. Signal form the first chip 300B may be coupled to the second chip 340A and transmit to the first interconnect structure 200.

The molding compound 412 is arranged on the first interconnect structure 200 and encapsulating the first chip 300B, the second chip 340A, the thermal interface material (TIM) 250A and the first RDL 230. Therefore, the second chip 340A is spaced apart from the first chip 300B the molding compound 412 and the thermal interface material (TIM) 250A.

As shown in FIG. 7, the semiconductor package 500G may optionally include a second RDL 240 arranged between the second chip 340A and the first interconnect structure 200 in the direction D12. The second RDL 240 is mounted on and coupled to the first interconnect structure 200 by a bonding process using the conductive structures 362. The conductive structures 282 and 362 may have the same or similar structure. In addition, the size (e.g., the diameter) of the conductive structures 362 may be smaller than or equal to the conductive structures 372.

As shown in FIG. 7, the second chip 340A may be optionally mounted on and coupled to the second RDL 240 by a bonding process using conductive structures 392. In some embodiments, the conductive structures 362 and 392 may have the same or similar structure and size (e.g., the diameter). For example, the conductive structures 392 may include conductive bumps or conductive pads.

As shown in FIG. 7, the through mold vias TMV1 are coupled between the first RDL 230 and the first interconnect structure 200. In addition, the through mold vias TMV 1 may surround the first chip 300B, the second chip 340A, the TIM 250A and the optional second RDL 240. In this embodiment, the through mold vias TMV1 may also serve as power through mold vias to transmit power to the first chip 300B.

The semiconductor packages 500F and 500G have the following advantages. In the semiconductor packages 500F and 500G, the first chip 300A having back-side power delivery network (BSPDN) (e.g., the back-side connect structure 320) may arrange signal routings in the front-side (FS) back end of line (BEOL) (e.g., the front-side connect structure 330) separated from the back-side (BS) power and ground routings in the BSPDN (e.g., the back-side connect structure 320). The signal routings may be coupled to the first RDL 230 using wired communication (including the through vias (e.g., the through vias TV1, TV3), and the redistribution layers (e.g., the second RDL 240) in epoxy molding compound (EMC) (e.g., the molding compound 412) and fan out wafer/panel level package (FOW/PLP) (e.g., the semiconductor packages 500F and 500G).

In some embodiments, the package structure of the semiconductor packages 500F and 500G can be chip-substrate-PCB structure (e.g., the first chip 300B disposed on the first interconnect structure 200 disposed on the base 100).

Compared with the signal input/output (I/O) in the conventional front-side power delivery network (FSPDN), signal integrity (SI) in the FS-BEOL (e.g., the front-side connect structure 330) of the first chips 300A (or the first chip 300B) of the semiconductor packages 500F and 500G can be relaxed as signals fully decouple from power/ground and directly or wirelessly input/output downward to the interposer-level (e.g., the first interconnect structure 200) and multi-layer RDL (e.g., the second RDL 240) and vias, which are scaled up in width, thickness, and gaps, and as signals are not proximal to power rails.

In the semiconductor packages 500G, the FS-BEOL (e.g., the front-side connect structure 330) of the first chip 300B to the interposer (e.g., the first interconnect structure 200) architecture allows communication between the BSPDN chip (e.g., the first chip 300B) and other chips (e.g., the second chip 340A) without BSPDN technology on the interposer level.

In the semiconductor packages 500F and 500G, the FS-BEOL (e.g., the front-side connect structure 330) of the first chip 300A (or the first chip 300B) facing downward allows 3D stacking on another BSPDN chip with FS facing up.

In the semiconductor packages 500F and 500G, power integrity (PI) in BS (e.g., the back-side connect structure 320) of the first chips 300A (or the first chip 300B) can be relaxed as all the area and layers are dedicated for power and ground rails in the BSPDN (e.g., the back-side connect structure 320), reducing isolation design and congestions for signals, optimizing inductance and PI, and increasing power delivery design flexibility. The dimension of FOW/PLP RDL (e.g., the first RDL 230 and the second RDL 240) and via can be equal or larger than those on interposer(e.g., the first interconnect structure 200), meaning lower resistance and the IR drop can be reduced.

It is noted that the semiconductor package 500E may also have advantages of the semiconductor packages 500F and 500G because the arrangement of the third chip 350A of the semiconductor package 500E is the same or similar to the first chip 300A of the semiconductor packages 500F and 500G.

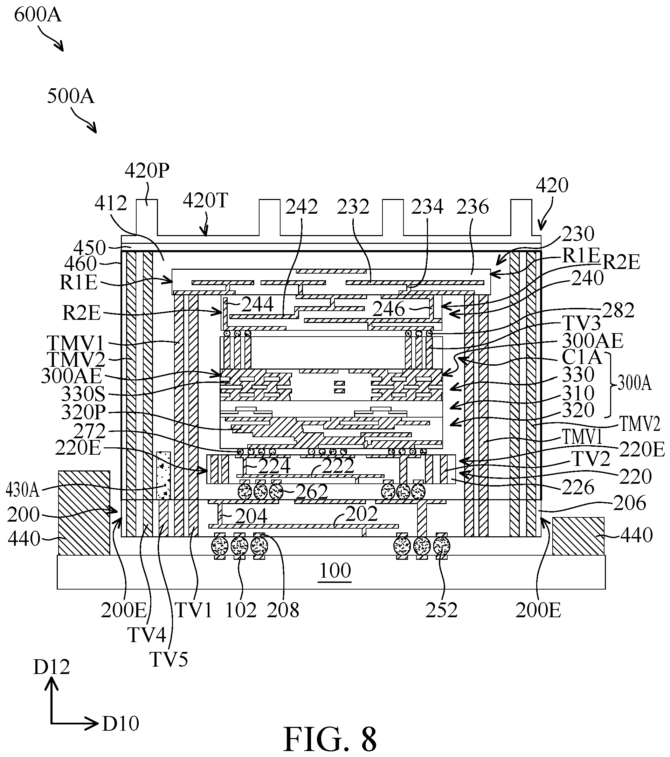

FIG. 8 is a schematic cross-sectional view of a semiconductor package assembly 600A including the semiconductor package 500A of FIG. 1 in accordance with some embodiments of the disclosure. Elements of the embodiments that are the same or similar to those previously described with reference to FIG. 1 are not repeated herein for the purpose of brevity. In some embodiments, the semiconductor package assembly 600A is a semiconductor package assembly including one or more fan-out packages, two-dimensional (2D) packages, 2.5D packages, three-dimensional (3D) semiconductor packages, or other suitable packages.

In some embodiments, the semiconductor package assembly 600A at least includes a base 100 and the semiconductor package 500A mounted on the base 100 using conductive structures 252.

In some embodiments, the semiconductor package 500A includes a first interconnect structure 200, a second interconnect structure 220, a first chip 300A, a first redistribution layer (RDL) 230, a second RDL 240, a molding compound 412, through mold vias (TMVs) TMV1, and conductive structures 262, 272 and 282. The first chip 300A is arranged over/on and coupled to the first interconnect structure 200. The first redistribution layer (RDL) 230 is arranged over/on the chip and coupled to the first chip 300A. The molding compound 412 is arranged on the first interconnect structure 200 and encapsulates the first chip 300A, the first RDL 230 and the second interconnect structure 220. The through mold vias TMV1 pass through the molding compound 412 and connected between the first RDL 230 and the first interconnect structure 200. The first chip 300A includes a first back-side connect structure 320, a first transistor layer 310, a first front-side connect structure 330 and a first carrier C1A. The first back-side connect structure 320 is connected to the first interconnect structure 200 by the conductive structures 272, the second interconnect structure 220 and the conductive structures 262. The first transistor layer 310 is located on the first back-side connect structure 320. The first front-side connect structure 330 is located on the first transistor layer 310. The first carrier C1A is located on the first front-side connect structure 330 and coupled to the first redistribution layer 230 by the second RDL 240 and the conductive structures 282.

In the semiconductor package 500A of the semiconductor package assembly 600A, the first back-side connect structure 320 is located close to the first interconnect structure 200. In addition, the first carrier C1A is located close to and coupled to the first RDL 230.

In some embodiments, the semiconductor package assembly 600A may further include a heat sink 420 mounted on the semiconductor package 500A. As shown in FIG. 8, the heat sink 420 is disposed on the top surface 412T of the molding compound 412. The heat sink 420 may completely cover the top surface 412T of the molding compound 412 to enhance the heat dissipation capability of the semiconductor package assembly 600A. In some embodiments, the heat sink 420 may be mounted on the top surface 412T of the molding compound 412 by a thermal interface material (TIM) 450 to further improve heat dissipation efficiency and speed up heat dissipation. In some embodiments, the TIMs 250A, 250B1, 250B2 and 450 may include the same or similar materials.

In some embodiments, the heat sink 420 may include at least one protrusion portion 420-P. The protrusion portion 420-P extends upwards form from a top surface 420T of the heat sink 420. In some embodiments, the fin-shaped protrusion portion 420-P may increase the surface area of the heat sink 420. Therefore, the heat dissipation capability of the semiconductor package assembly 600A can be further improved.

In some embodiments, the semiconductor package assembly 600A may further include thermal through mold vias (TMVs) TMV2. The thermal through mold vias TMV2 may help to dissipate the heat generated form the semiconductor package 500A to the environment outside the semiconductor package assembly 600A. As shown in FIG. 8, the thermal through mold vias TMV2 may pass through the molding compound 412 of the semiconductor package 500A in the direction D12. In some embodiments, the thermal through mold vias TMV2 may be connected to through vias TV4 of the first interconnect structure 200 of the semiconductor package 500A and the heat sink 420. In the first interconnect structure 200, the through vias TV4 coupled to the thermal through mold vias TMV2 may be isolated from the through vias TV1 coupled to the through mold vias TMV1. In addition, the thermal through mold vias TMV2 may be connected to the heat sink 420 by the TIM 450. In some embodiments, the thermal TMVs TMV2 are arranged surrounding the first chip 300A and the through mold vias TMV1 (e.g., signaling and/or power through mold vias) of the semiconductor package 500A.

In some embodiments, the thermal through mold vias TMV2 and TIM 450 may include high thermal conductivity materials, such as copper, diamond, aluminum nitride, boron nitride, or other applicable high thermal conductivity materials. In some embodiments, the through mold vias TMV1 and the thermal through mold vias TMV2 include different materials.

In some embodiments, the semiconductor package assembly 600A may provide a heat dissipating path for the semiconductor package 500A. Heat generated form the semiconductor package 500A may dissipate through the first interconnect structure 200, the second interconnect structure 220, the conductive structures 252, 262, 272, the thermal through mold vias TMV2, the TIM 450 and the heat sink 420. The thermal through mold vias TMV2, the TIM 450 and the heat sink 420 may improve heat dissipation efficiency from the semiconductor package 500A to the environment outside the semiconductor package assembly 600A.

In some embodiments, the semiconductor package assembly 600A may further include a voltage regulator 430A disposed in the molding compound 412 of the semiconductor package. The voltage regulator 430A may be disposed on the first interconnect structure 200 and coupled to through vias TV5 of the first interconnect structure 200 of the semiconductor package 500A. In the first interconnect structure 200, the through vias TV5 coupled to the voltage regulator 430A may be isolated from the through vias TV1 coupled to the through mold vias TMV1. In addition, the voltage regulator 430A may be coupled to the first chip 300A through the first interconnect structure 200 and the second interconnect structure 220. Furthermore, the voltage regulator 430A may be coupled to the base 100. In some embodiments, the voltage regulator 430A may be used to provide a stable voltage for use in circuits in the semiconductor package assembly 600A.

In some embodiments, the semiconductor package assembly 600A may further include at least one power delivery related component 440. In some embodiments, the power delivery related component 440 is disposed on the base 100. In addition, the power delivery related component 440 may be arranged beside the semiconductor package 500A in the direction D10 (i.e., the lateral direction).

In some embodiments, the power delivery related component 440 may include a passive device (such as a capacitor and/or an inductor, an active device (such as a power management integrated circuit (PMIC), a voltage regulator, etc.), a flexible printed circuit, or other applicable power delivery related components.

In some embodiments, the semiconductor package assembly 600A may further include an electromagnetic (EM) shielding layer 460. In some embodiments, the electromagnetic (EM) shielding layer 460 may cover at least a portion of a surface of the semiconductor package 500A. For example, the electromagnetic (EM) shielding layer 460 may completely cover the top surface 412T and the edges 412E of the molding compound 412. The edges 200E of the first interconnect structure 200 may be exposed form the electromagnetic (EM) shielding layer 460. In some embodiments, the electromagnetic (EM) shielding layer 460 may be integrated with the semiconductor package assembly 600A.

In some embodiments, the electromagnetic (EM) shielding layer 460 may protect the chips (e.g., the first chip 300A) of the semiconductor package 500A from the interference or noise from the digital circuitry (e.g., the power delivery related component 440).

In some embodiments, the electromagnetic (EM) shielding layer 460 formed of metal may be connected between the TIM 450 and the thermal through mold vias TMV2 to further improve heat dissipation efficiency and speed up heat dissipation.

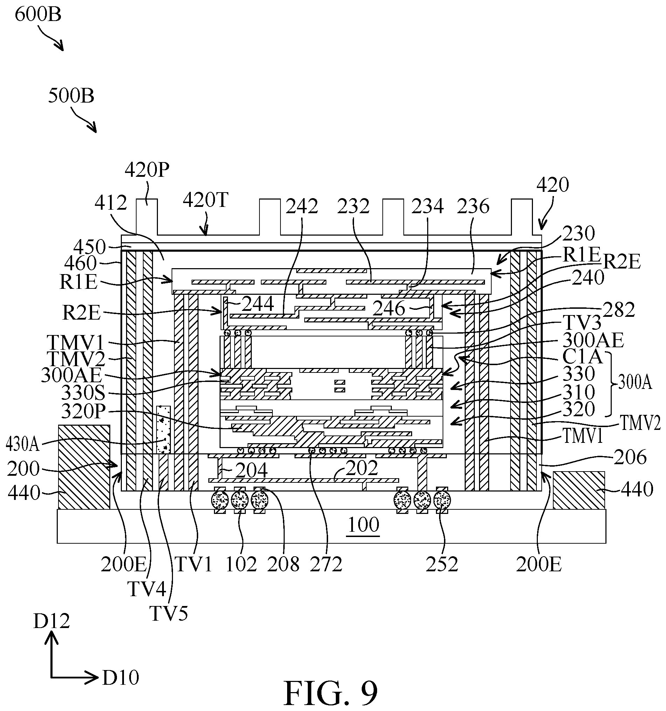

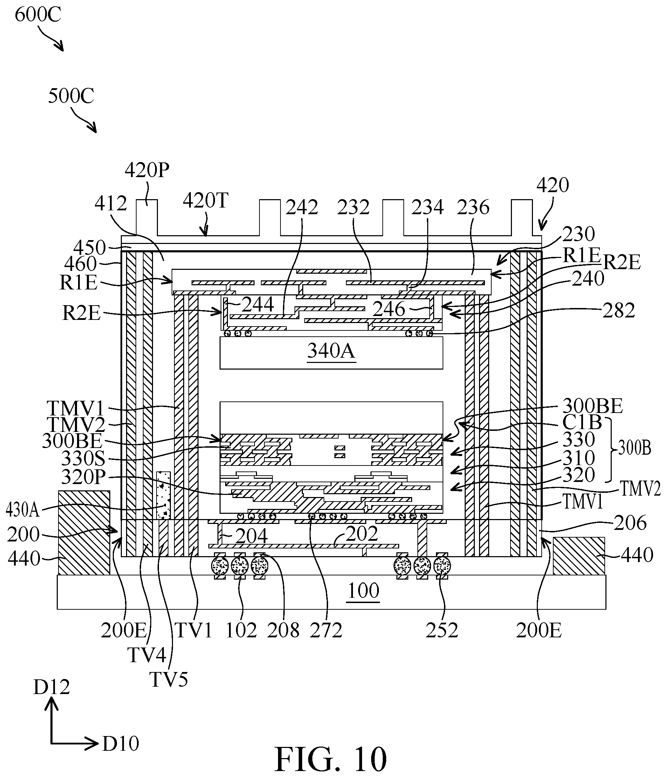

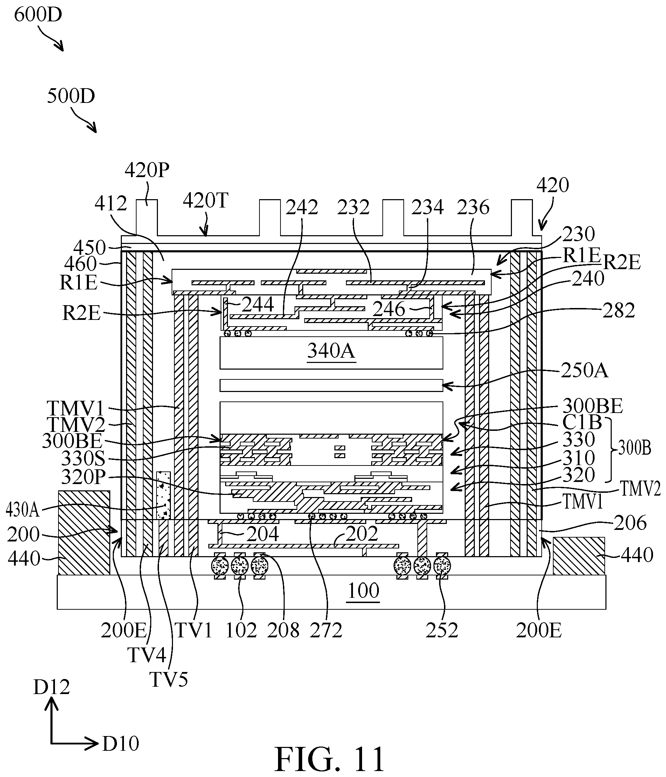

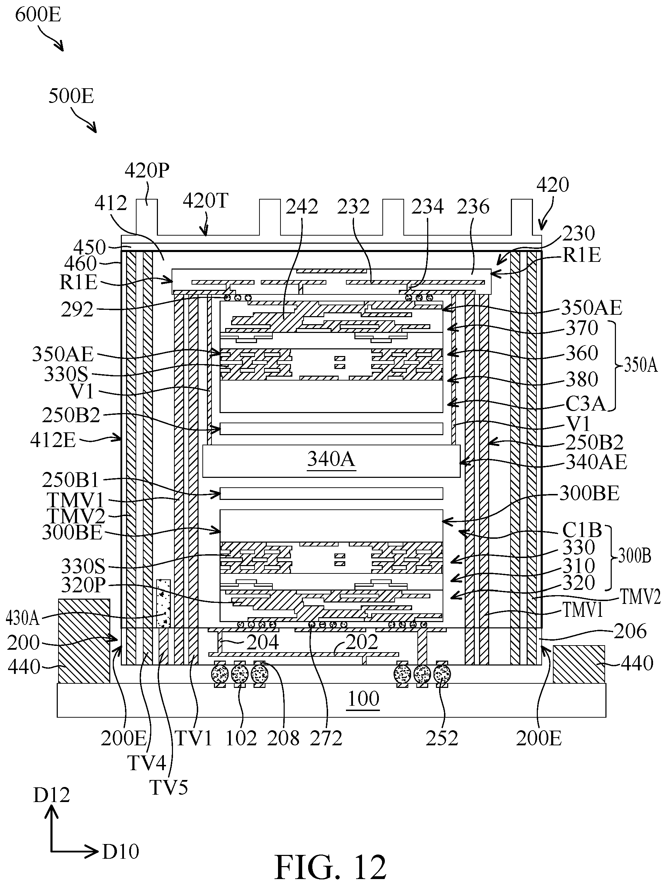

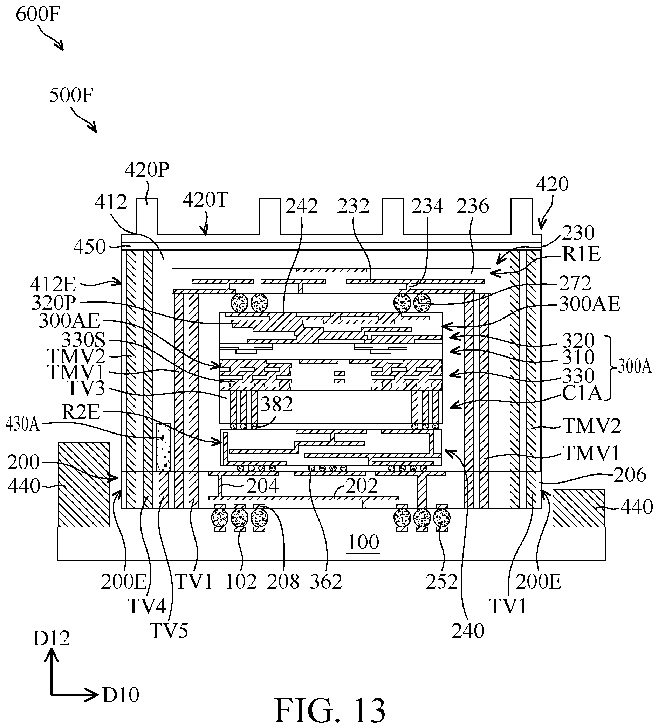

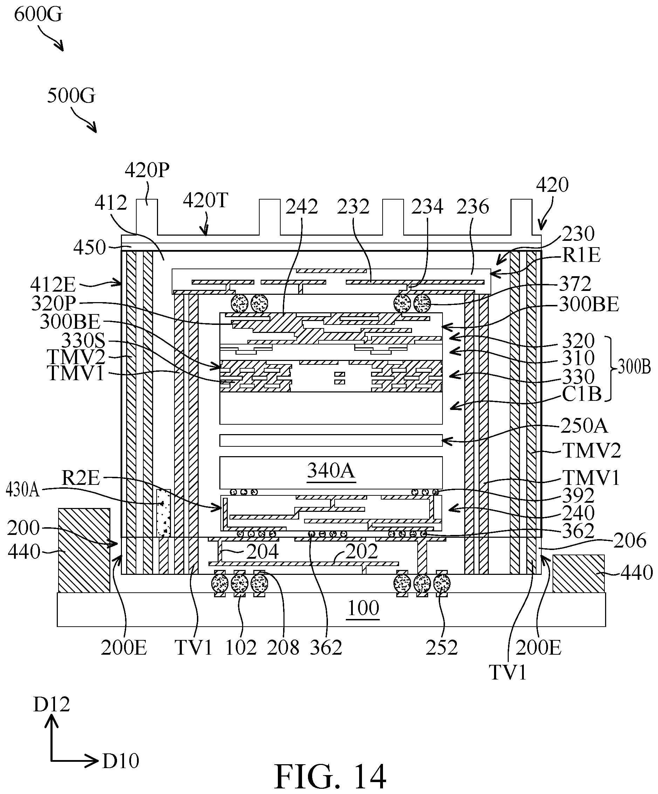

FIGS. 9, 10, 11, 12, 13 and 14 is a schematic cross-sectional view of a semiconductor package assemblies 600B, 600C, 600D, 600E, 600F, and 600G including the semiconductor packages 500B, 500C, 500D, 500E, 500F, and 500G of FIGS. 2, 3, 4, 5, 6, and 7 in accordance with some embodiments of the disclosure. Elements of the embodiments that are the same or similar to those previously described with reference to FIGS. 1 to 8 are not repeated herein, in the interests of brevity.

In some embodiments, the semiconductor package assembly 600B at least includes a base 100 and the semiconductor package 500B mounted on the base 100 using conductive structures 252. The semiconductor package assembly 600C at least includes a base 100 and the semiconductor package 500C mounted on the base 100 using conductive structures 252. The semiconductor package assembly 600D at least includes a base 100 and the semiconductor package 500D mounted on the base 100 using conductive structures 252. The semiconductor package assembly 600E at least includes a base 100 and the semiconductor package 500E mounted on the base 100 using conductive structures 252. The semiconductor package assembly 600F at least includes a base 100 and the semiconductor package 500F mounted on the base 100 using conductive structures 252. The semiconductor package assembly 600G at least includes a base 100 and the semiconductor package 500G mounted on the base 100 using conductive structures 252.

In some embodiments, the elements of the semiconductor packages 500B, 500C, 500D, 500E, 500F and 500G are the same or similar to those in the previously described semiconductor packages 500B, 500C, 500D, 500E, 500F and 500G with reference to FIGS. 2, 3, 4, 5 and 6, and they are not repeated herein, in the interests of brevity.

In some embodiments, each of the semiconductor package assemblies 600B, 600C, 600D, 600E, 600F, and 600G may further includes a heat sink 420, a TIM 450, thermal through mold vias TMV2, a voltage regulator 430A, at least one power delivery related component 440, and an electromagnetic (EM) shielding layer 460. The arrangements of the heat sink 420, the TIM 450, the thermal through mold vias TMV2, the voltage regulator 430A, the power delivery related component 440, and the electromagnetic (EM) shielding layer 460 are the same or similar to those in the previously described semiconductor package assembly 600A with reference to FIG. 8, and they are not repeated herein, in the interests of brevity.

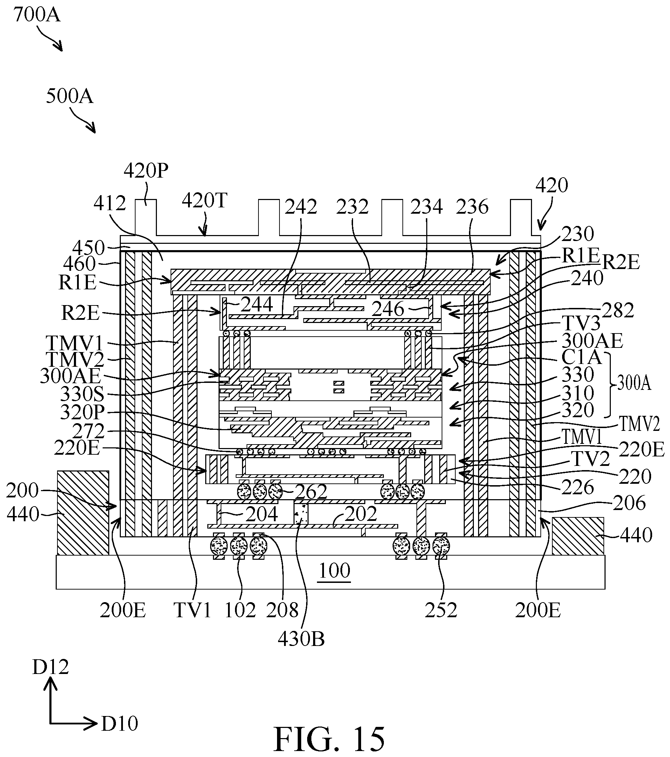

FIG. 15 is a schematic cross-sectional view of a semiconductor package assembly 700A including the semiconductor package 500A in accordance with some embodiments of the disclosure. Elements of the embodiments that are the same or similar to those previously described with reference to FIG. 8 are not repeated herein, in the interests of brevity. As shown in FIGS. 8 and 15, the difference between the semiconductor package assembly 600A and the semiconductor package assembly 700A at least includes that a voltage regulator 430B of the semiconductor package assembly 700A disposed in the first interconnect structure 200 of the semiconductor package 500A.

As shown in FIG. 15, the voltage regulator 430B is embedded in the first interconnect structure 200 and coupled to the conductive traces 202. In addition, the voltage regulator 430B may be coupled to the first chip 300A through the first interconnect structure 200 and the second interconnect structure 220. Furthermore, the voltage regulator 430B may be coupled to the base 100. In some embodiments, the voltage regulator 430B may be used to provide a stable voltage for use in circuits in the semiconductor package assembly 700A. In some embodiments, the voltage regulator 430B may be formed integrated with the first interconnect structure 200.

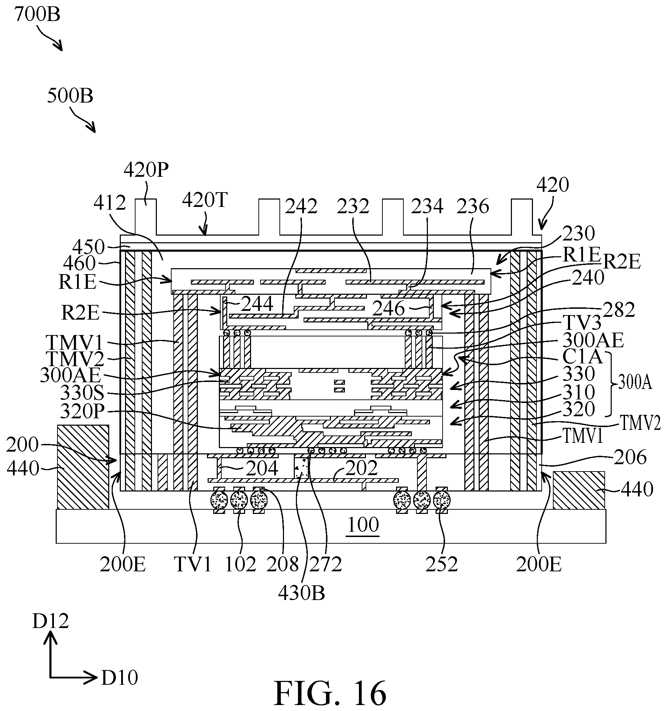

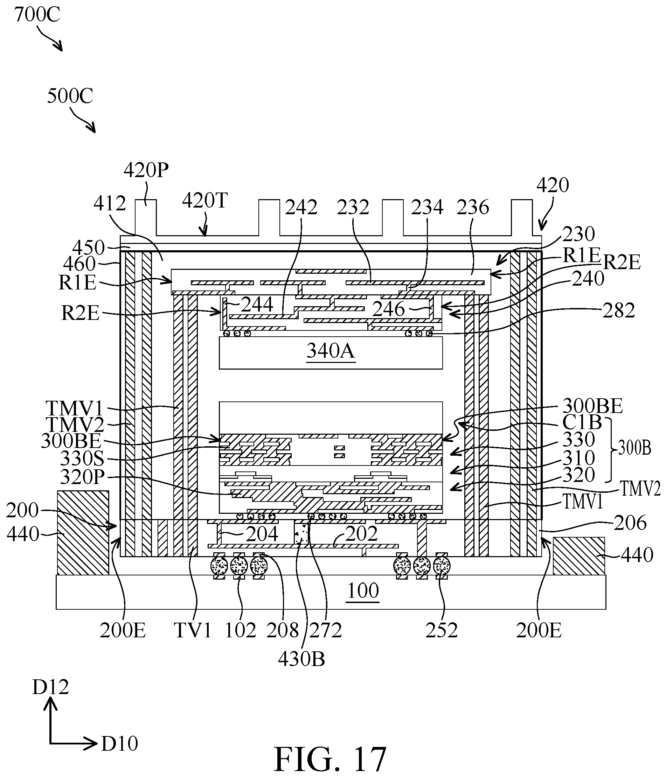

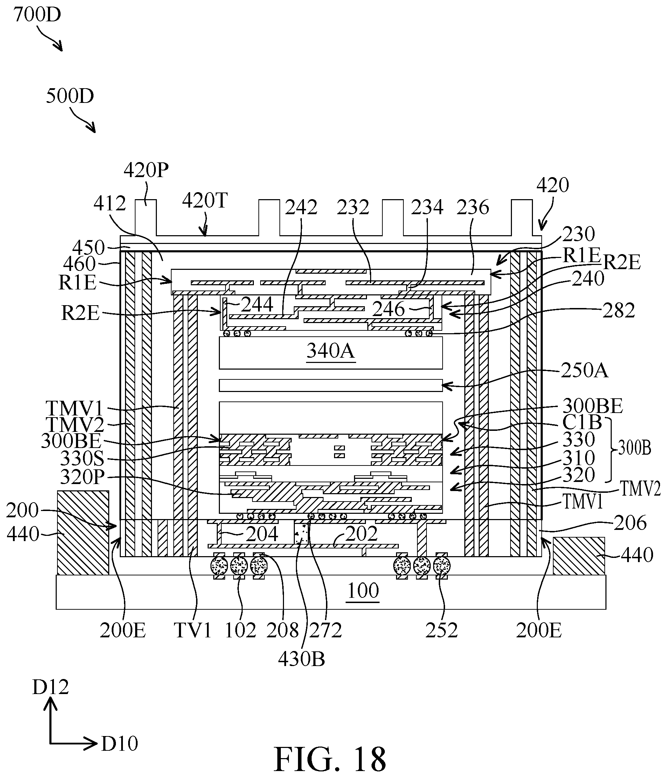

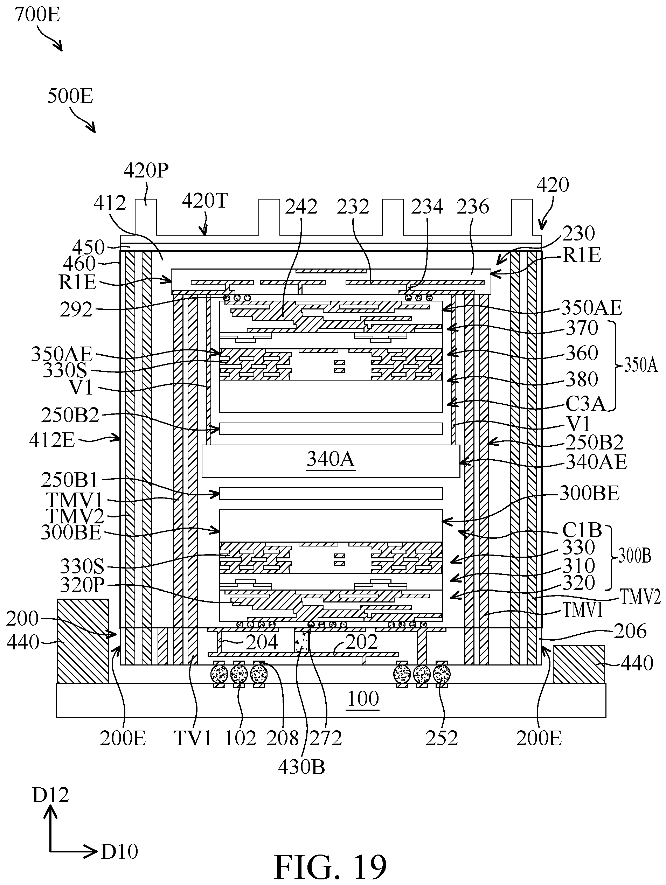

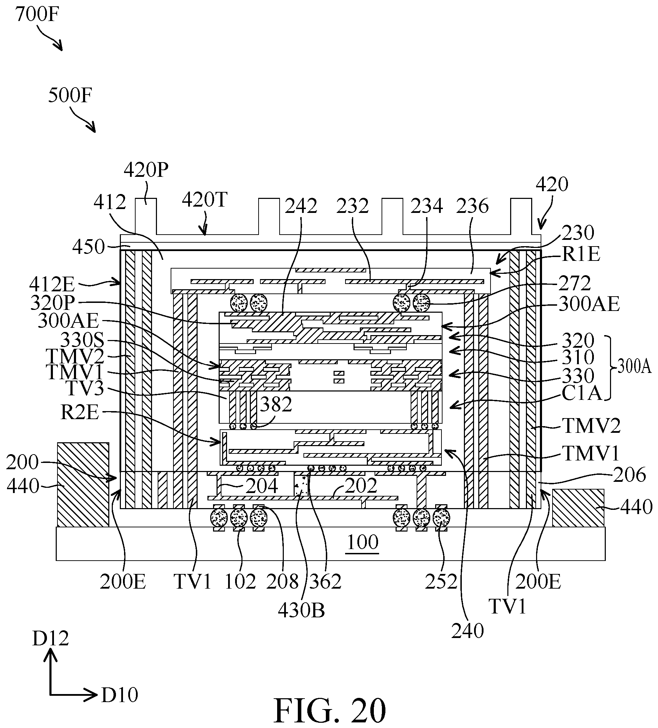

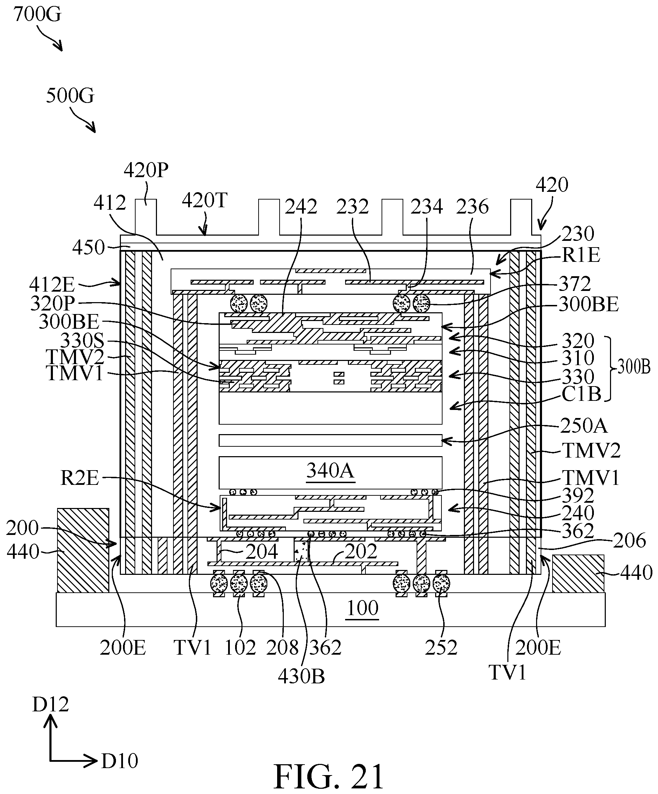

FIGS. 16, 17, 18, 19, 20 and 21 is a schematic cross-sectional view of a semiconductor package assemblies 700B, 700C, 700D, 700E, 700F, and 700G including the semiconductor packages 500B, 500C, 500D, 500E, 500F, and 500G of FIGS. 2, 3, 4, 5, 6, and 7 in accordance with some embodiments of the disclosure. Elements of the embodiments that are the same or similar to those previously described with reference to FIGS. 1 to 15 are not repeated herein, in the interests of brevity.

In some embodiments, the semiconductor package assembly 700B at least includes a base 100 and the semiconductor package 500B mounted on the base 100 using conductive structures 252. The semiconductor package assembly 700C at least includes a base 100 and the semiconductor package 500C mounted on the base 100 using conductive structures 252. The semiconductor package assembly 700D at least includes a base 100 and the semiconductor package 500D mounted on the base 100 using conductive structures 252. The semiconductor package assembly 700E at least includes a base 100 and the semiconductor package 500E mounted on the base 100 using conductive structures 252. The semiconductor package assembly 700F at least includes a base 100 and the semiconductor package 500F mounted on the base 100 using conductive structures 252. The semiconductor package assembly 700G at least includes a base 100 and the semiconductor package 500G mounted on the base 100 using conductive structures 252.

In some embodiments, the elements of the semiconductor packages 500B, 500C, 500D, 500E, 500F and 500G are the same or similar to those in the previously described semiconductor packages 500B, 500C, 500D, 500E, 500F and 500G with reference to FIGS. 2, 3, 4, 5 and 6, and they are not repeated herein, in the interests of brevity.

In some embodiments, each of the semiconductor package assemblies 700B, 700C, 700D, 700E, 700F, and 700G may further includes a voltage regulator 430B disposed in the first interconnect structure 200. The arrangements of the voltage regulator 430B are the same or similar to those in the previously described semiconductor package assembly 700A with reference to FIG. 15, and they are not repeated herein, in the interests of brevity.

In some embodiments, each of the semiconductor package assemblies 700B, 700C, 700D, 700E, 700F, and 700G may further includes a heat sink 420, a TIM 450, thermal through mold vias TMV2, at least one power delivery related component 440, and an electromagnetic (EM) shielding layer 460. The arrangements of the heat sink 420, the TIM 450, the thermal through mold vias TMV2, the power delivery related component 440, and the electromagnetic (EM) shielding layer 460 are the same or similar to those in the previously described semiconductor package assembly 700A with reference to FIG. 15, and they are not repeated herein, in the interests of brevity.

It is appreciated that although some features are shown in some embodiments but not in other embodiments, these features may (or may not) exist in other embodiments whenever possible. For example, although each of the illustrated example embodiments of FIGS. 15-21 shows specific arrangements of the voltage regulator 430B, any other combinations of arrangements of the voltage regulator may also be used whenever applicable. In addition, the semiconductor package assembly may include a plurality of voltage regulators having combinations of arrangements of the voltage regulators 430A and 430B of the semiconductor package assemblies 600A-600G and 700A-700G, whenever applicable.

In addition to the advantages of the semiconductor package 500A, 500B, 500C, 500D, 500E, 500F, and 500G, the semiconductor package assemblies 600A-600G and 700A-700G further have the following advantages. In the semiconductor package assemblies 600A-600G and 700A-700G, thermal interface materials (TIMs) can be applied inside the thermal TMVs (e.g., the TIM 250A, 250B1, 250B2 can be applied inside the thermal through mold vias TMV2) or on top of the fan out wafer/panel level package (FOW/PLP) (e.g., the TIM 450 can be applied on the top surface 412T of the semiconductor packages 500A-500G), followed by a heat sink (e.g., the heat sink 420). In addition, the thermal TMV and TIM can be formed of any high thermal conductivity material, such as a metal or a metal alloy including Al, Cu, Ni, Co, diamond, aluminum nitride, boron nitride, etc., or other high thermal conductivity material. Further, the voltage regulator (e.g., the voltage regulator 430) can be integrated inside a glass/Si/organic interposer or inside a substrate (e.g., the embedded voltage regulator 430B in the first interconnect structure 200 in semiconductor package assemblies 700A-700G of FIGS. 15-21) or as a stand-alone component (e.g., the bulk voltage regulator 430A disposed on the first interconnect structure 200 in semiconductor package assemblies 600A-600G of FIGS. 8-14).

Embodiments provide a semiconductor package. The semiconductor package includes a first interconnect structure, a first chip, a first redistribution layer (RDL), a molding compound, and through mold vias (TMVs). The first chip is arranged over/on the first interconnect structure and coupled to the first interconnect structure. The first redistribution layer (RDL) is arranged over/on and coupled to the first chip. The molding compound is arranged on the first interconnect structure and encapsulates the first chip and the first RDL. The through mold vias (TMVs) pass through the molding compound and are connected between the first RDL and the first interconnect structure. The first chip includes a first back-side connect structure, a first transistor layer, a first front-side connect structure and a first carrier. The first back-side connect structure is connected to the first interconnect structure. The first transistor layer is located on the first back-side connect structure. The first front-side connect structure is located on the first transistor layer. The first carrier is located on and coupled to the first interconnect structure.

In some embodiments, the first back-side connect structure is located close to the first interconnect structure, and the first carrier is located close to and coupled to the first RDL.

In some embodiments, the first interconnect structure includes an interposer, a substrate or an RDL.

In some embodiments, the first carrier is a silicon wafer carrier.

In some embodiments, the first carrier includes through vias (TVs) passing through the first carrier and connected between the first front-side connect structure and the first RDL.

In some embodiments, the semiconductor package further includes a second RDL arranged between the first carrier and the first RDL.

In some embodiments, the second RDL mounted on the first carrier by conductive structures.

In some embodiments, the semiconductor package further includes a second interconnect structure between the first interconnect structure and the first chip.

In some embodiments, the second interconnect structure includes an interposer or an RDL.

In some embodiments, the through mold vias (TMVs) are arranged surrounding the first chip.

In some embodiments, the first transistor layer includes at least one transistor.

In some embodiments, the first back-side connect structure is used for connecting to a power supply and/or a ground, or the first back-side connect structure is used for connecting to a power supply and/or a ground and is also used for signal transmission.

In some embodiments, the first front-side connect structure is used for signal transmission.

1 In some embodiments, the semiconductor package further includes conductive structures disposed on the first interconnect structure and opposite to the first chip.

In some embodiments, the semiconductor package further includes a second chip arranged over/on and spaced apart from the first chip, wherein the second chip is encapsulated by the molding compound.

In some embodiments, the second chip is a transceiver chip.

In some embodiments, the semiconductor package further includes a thermal interface material (TIM) disposed between the first chip and the second chip.

In some embodiments, the second chip and the first chip are coupled by near-field coupling. Near-field coupling may include electrical coupling, magnetic coupling and/or electromagnetic coupling.

In some embodiments, the second chip includes a logic chip, a memory chip, a radio frequency (RF) chip or/and analog chip having a transceiver function.

In some embodiments, the semiconductor package further includes a third chip arranged over/on the second chip, and the third chip is coupled to the first RDL.

In some embodiments, the third chip includes a third back-side connect structure, a third transistor layer, a third front-side connect structure and a third carrier. The third back-side connect structure is connected to the first RDL. The third transistor layer is located on the third back-side connect structure. The third front-side connect structure is located on the third transistor layer. The third carrier is located on the front-side connect structure.

In some embodiments, the third chip is spaced apart from the first chip by the molding compound, or the third chip is spaced apart from the first chip by the molding compound and a thermal interface material (TIM).

In some embodiments, the third chip and the second chip are coupled by near-field coupling. Near-field coupling may include electrical coupling, magnetic coupling and/or electromagnetic coupling.

In some embodiments, the second chip is connected to the first RDL by first vias embedded in the molding compound.

In some embodiments, the first carrier is located close to the first interconnect structure, and the first back-side connect structure is located close to and coupled to the first RDL.

In some embodiments, the first carrier includes through vias (TVs) passing through the first carrier and connected between the first front-side connect structure and the first interconnect structure.

In some embodiments, the semiconductor package further includes a second chip arranged between the first interconnect structure and the first chip. The second chip is spaced apart from the first chip by the molding compound. The first carrier is located above the second chip.

Embodiments provide a semiconductor package assembly. The semiconductor package assembly includes a base and a semiconductor package mounted on the base. The semiconductor package includes a first interconnect structure, a first chip, a first redistribution layer (RDL), a molding compound and through mold vias (TMVs). The first chip is arranged over/on the first interconnect structure and coupled to the first interconnect structure. The first redistribution layer (RDL) is arranged over/on and coupled to the first chip. The molding compound is arranged on the first interconnect structure and encapsulates the first chip and the first RDL. The through mold vias (TMVs) passes through the molding compound and are connected between the first RDL and the first interconnect structure. The first chip includes a first back-side connect structure, a first transistor layer, a first front-side connect structure, and a first carrier. The first back-side connect structure is connected to the first interconnect structure. The first transistor layer is located on the first back-side connect structure. The first front-side connect structure is located on the first transistor layer. The first carrier is located on the first front-side connect structure and coupled to the first interconnect structure. The first back-side connect structure is located close to the first interconnect structure and the first carrier is located close to and coupled to the first RDL. Alternatively, the first carrier is located close to the first interconnect structure and the first back-side connect structure is located close to and coupled to the first RDL.

In some embodiments, the semiconductor package assembly further includes a heat sink mounted on the semiconductor package.

In some embodiments, the heat sink is mounted on the semiconductor package by a TIM.

In some embodiments, the semiconductor package assembly further includes thermal through mold vias (TMVs) passing through the molding compound of the semiconductor package and connected to the first interconnect structure of the semiconductor package and the heat sink.

In some embodiments, the thermal TMVs are arranged surrounding the first chip of the semiconductor package.

In some embodiments, the semiconductor package assembly further includes a voltage regulator disposed in the molding compound or in the first interconnect structure of the semiconductor package.

In some embodiments, the semiconductor package assembly further includes at least one power delivery related component disposed on the base.

In some embodiments, the semiconductor package assembly further includes an electromagnetic (EM) shielding layer covering at least a portion of a surface of the semiconductor package and/or disposed within the semiconductor package.

The semiconductor package and the semiconductor package assembly in accordance with some embodiments of the disclosure another type of BSPDN (back-side power delivery network) to solve the aforementioned problems. For example, as signals reach the topmost metal layer of a back end of line (BEOL) metal system on a chip, signals may be transmitted by wired transmission or both wireless and wired transmission going outward of the chip to support critical signals. In addition, the chip may face up or down in single-chip or multi-chip stacking in a package using 2.xD/3D homogeneous and heterogeneous integration. The structures and requirements for the chip, package, and base (e.g., a PCB) are collectively optimized. In some embodiments, the elements for wireline transmission may include bumps (optional), through vias (TV), redistribution layers (RDLs) and through molding vias (TMVs) in epoxy molding compound (EMC) using fan out wafer/panel level packaging (FOW/PLP). In some embodiments, the elements for both wireless and wired transmission may include bumps (optional), redistribution layers (RDLs) and through molding vias (TMVs) in epoxy molding compound (EMC) using fan out wafer/panel level packaging (FOW/PLP), and near-field coupling (includes electrical (e.g., capacitive) coupling, magnetic (e.g., inductive) coupling or electromagnetic (e.g., radiation) coupling) among chips.

While the disclosure has been described by way of example and in terms of the preferred embodiments, it should be understood that the disclosure is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

Various embodiments are set out in the following numbered clauses.

Clause 1. A semiconductor package, comprising: a first interconnect structure; a first chip arranged on and coupled to the first interconnect structure; a first redistribution layer (RDL) arranged on and coupled to the first chip; a molding compound arranged on the first interconnect structure and encapsulating the first chip and the first RDL; and through mold vias (TMVs) passing through the molding compound and connected between the first RDL and the first interconnect structure, wherein the first chip comprises: a first back-side connect structure coupled to the first interconnect structure; a first transistor layer located on the first back-side connect structure; a first front-side connect structure located on the first transistor layer; and a first carrier located on and coupled to the first interconnect structure.

Clause 2. The semiconductor package as in Clause 1, wherein the semiconductor package further comprises a second RDL arranged between the first carrier and the first RDL.

Clause 3. The semiconductor package as in Clause 1, wherein the semiconductor package further comprises a second interconnect structure between the first interconnect structure and the first chip.

Clause 4. The semiconductor package as in Clause 1, wherein the through mold vias (TMVs) are arranged surrounding the first chip.

Clause 5. The semiconductor package as in Clause 1, wherein the first back-side connect structure is arranged for coupling to a power supply or a power supply and a ground, or the first back-side connect structure is arranged for coupling to a power supply or a power supply and a ground and is further arranged for signal transmission.

Clause 6. The semiconductor package as in Clause 5, wherein the first front-side connect structure is arranged for signal transmission.

Clause 7. The semiconductor package as in Clause 1, further comprising: a second chip arranged on and spaced apart from the first chip, wherein the second chip is encapsulated by the molding compound.

Clause 8. The semiconductor package as in Clause 7, wherein the second chip is a transceiver chip.

Clause 9. The semiconductor package as in Clause 8, further comprising a thermal interface material (TIM) disposed between the first chip and the second chip.

Clause 10. The semiconductor package as in Clause 8, wherein the second chip and the first chip are coupled by near-field coupling comprising electrical coupling, magnetic coupling and/or electromagnetic coupling.

Clause 11. The semiconductor package as in Clause 8, wherein the semiconductor package further comprises a third chip arranged on the second chip, and the third chip is coupled to the first RDL.

Clause 12. The semiconductor package as in Clause 11, wherein the third chip comprises: a third back-side connect structure connected to the first RDL; a third transistor layer located on the third back-side connect structure; a third front-side connect structure located on the third transistor layer; and a third carrier located on the front-side connect structure.

Clause 13. The semiconductor package as in Clause 11, wherein the third chip is spaced apart from the first chip by the molding compound, or the third chip is spaced apart from the first chip by the molding compound and a thermal interface material (TIM).

Clause 14. The semiconductor package as in Clause 11, wherein the third chip and the second chip are coupled by near-field coupling comprising electrical coupling, magnetic coupling and/or electromagnetic coupling.

Clause 15. The semiconductor package as in Clause 11, wherein the second chip is connected to the first RDL by first vias embedded in the molding compound.

Clause 16. The semiconductor package as in Clause 1, wherein the first carrier is located close to the first interconnect structure, and the first back-side connect structure is located close to and coupled to the first RDL.

Clause 17. The semiconductor package as in Clause 16, wherein the first carrier comprises through vias (TVs) passing through the first carrier and connected between the first front-side connect structure and the first interconnect structure.

Clause 18. The semiconductor package as in Clause 17, further comprising: a second chip arranged between the first interconnect structure and the first chip, wherein the second chip is spaced apart from the first chip by the molding compound, and wherein the first carrier located above the second chip.

Clause 19. A semiconductor package assembly, comprising: a base; and a semiconductor package mounted on the base, wherein the semiconductor package comprises: a first interconnect structure; a first chip arranged on and coupled to the first interconnect structure; a first redistribution layer (RDL) arranged on and coupled to the first chip; a molding compound arranged on the first interconnect structure and encapsulating the first chip and the first RDL; and through mold vias (TMVs) passing through the molding compound and connected between the first RDL and the first interconnect structure, wherein the first chip comprises: a first back-side connect structure connected to the first interconnect structure; a first transistor layer located on the first back-side connect structure; a first front-side connect structure located on the first transistor layer; and a first carrier located on the first front-side connect structure and coupled to the first interconnect structure, wherein the first back-side connect structure is located close to the first interconnect structure and the first carrier is located close to and coupled to the first RDL, or wherein the first carrier is located close to the first interconnect structure and the first back-side connect structure is located close to and coupled to the first RDL.

Clause 20. The semiconductor package assembly as in Clause 19, wherein the semiconductor package assembly further comprises thermal through mold vias (TMVs) passing through the molding compound of the semiconductor package and connected to the first interconnect structure of the semiconductor package and the heat sink.

## Claims

1. A semiconductor package (500A, 500B, 500C, 500D, 500E, 500F, 500G), comprising:
a first interconnect structure (200);
a first chip (300A, 300B, 350A) arranged on and coupled to the first interconnect structure (200);
a first redistribution layer (RDL) (230) arranged on and coupled to the first chip (300A, 300B, 350A);
a molding compound (412) arranged on the first interconnect structure (200) and encapsulating the first chip (300A, 300B, 350A) and the first RDL (230); and
through mold vias (TMVs) (TMV1) passing through the molding compound (412) and connected between the first RDL (230) and the first interconnect structure (200),
wherein the first chip (300A, 300B, 350A) comprises:
a first back-side connect structure (320, 370) coupled to the first interconnect structure (200);
a first transistor layer (310, 360) located on the first back-side connect structure (320, 370);
a first front-side connect structure (330, 380) located on the first transistor layer (310, 360); and
a first carrier (C1A, C1B, C3A) located on and coupled to the first interconnect structure (200).

2. The semiconductor package (500A, 500B, 500C, 500D, 500E, 500F, 500G) as claimed in claim 1, wherein the through mold vias (TMVs) (TMV1) are arranged surrounding the first chip (300A, 300B, 350A).

3. The semiconductor package (500A, 500B, 500C, 500D, 500E, 500F, 500G) as claimed in any one of claims 1 to 2, wherein the first back-side connect structure (320, 370) is arranged for coupling to a power supply or a power supply and a ground, or the first back-side connect structure (320, 370) is arranged for coupling to a power supply or a power supply and a ground and is further arranged for signal transmission.

4. The semiconductor package (500A, 500B, 500C, 500D, 500E, 500F, 500G) as claimed in claim 3, wherein the first front-side connect structure (330, 380) is arranged for signal transmission.

5. The semiconductor package (500A, 500B, 500C, 500D) as claimed in any one of claims 1 to 4, wherein the semiconductor package further comprises a second RDL (240) arranged between the first carrier (C1A, C1B) and the first RDL (230).

6. The semiconductor package (500A) as claimed in any one of claims 1 to 4, wherein the semiconductor package further comprises a second interconnect structure (220) between the first interconnect structure (200) and the first chip (300A).

7. The semiconductor package (500C, 500D, 500E) as claimed in any one of claims 1 to 4, further comprising:
a second chip (340A) arranged on and spaced apart from the first chip (300B, 350A), wherein the second chip (340A) is encapsulated by the molding compound (412),
optionally wherein the second chip (340A) is a transceiver chip,
optionally wherein the second chip (340A) and the first chip (300B, 350A) are coupled by near-field coupling comprising electrical coupling, magnetic coupling and/or electromagnetic coupling.

8. The semiconductor package (500D, 500E) as claimed in claim 7, further comprising a thermal interface material (TIM) (250A, 250B1, 250B2) disposed between the first chip (300A, 300B, 350A) and the second chip (340A).

9. The semiconductor package (500E) as claimed in claim 7, wherein the semiconductor package further comprises a third chip (350A) arranged on the second chip (340A), and the third chip is coupled to the first RDL (230).

10. The semiconductor package (500E) as claimed in claim 9, wherein the third chip (350A) comprises:
a third back-side connect structure (370) connected to the first RDL (230);
a third transistor layer (360) located on the third back-side connect structure (370);
a third front-side connect structure (380) located on the third transistor layer; and
a third carrier (C3A) located on the third front-side connect structure (380).

11. The semiconductor package (500E) as claimed in claim 9, wherein the third chip (350A) is spaced apart from the first chip (300B) by the molding compound (412), or the third chip (350A) is spaced apart from the first chip (300B) by the molding compound (412) and a thermal interface material (TIM) (250B2); and/or
wherein the third chip (350A) and the second chip (340A) are coupled by near-field coupling comprising electrical coupling, magnetic coupling and/or electromagnetic coupling.

12. The semiconductor package (500E) as claimed in claim 9, wherein the second chip (340A) is connected to the first RDL (230) by first vias (V1) embedded in the molding compound (412).

13. The semiconductor package (500E, 500F, 500G) as claimed in any one of claims 1 to 4, wherein the first carrier (C1B, C3A) is located close to the first interconnect structure (200), and the first back-side connect structure (320, 370) is located close to and coupled to the first RDL (230).

14. The semiconductor package (500F) as claimed in claim 13, wherein the first carrier (C1A) comprises through vias (TVs) (TV3) passing through the first carrier (C1A) and connected between the first front-side connect structure (330) and the first interconnect structure (200).

15. The semiconductor package (500G) as claimed in claim 13, further comprising:
a second chip (340A) arranged between the first interconnect structure (200) and the first chip (300B), wherein the second chip (340A) is spaced apart from the first chip (300B) by the molding compound (412), and
wherein the first carrier (C1B) located above the second chip (340A).
